(19) Europäisches Patentamt
European Patent Office
Office européen des brevets

(11) EP 3 175 297 B1

(12) **EUROPÄISCHE PATENTSCHRIFT**

(45) Veröffentlichungstag und Bekanntmachung des Hinweises auf die Patenterteilung:
**23.10.2019 Patentblatt 2019/43**

(21) Anmeldenummer: **15745464.6**

(22) Anmeldetag: **31.07.2015**

(51) Int Cl.:
***G03F 7/027*** (2006.01) ***G03F 7/035*** (2006.01)

(86) Internationale Anmeldenummer:
**PCT/EP2015/067652**

(87) Internationale Veröffentlichungsnummer:
**WO 2016/016426 (04.02.2016 Gazette 2016/05)**

(54) **SCHICHTAUFBAU UMFASSEND EINE PHOTOPOLYMER- UND EINE SUBSTRATSCHICHT**

LAYER STRUCTURE COMPRISING A PHOTO POLYMER AND A SUBSTRATE LAYER

MONTAGE EN COUCHE COMPRENANT UNE COUCHE DE SUBSTRAT ET UNE COUCHE DE PHOTO-POLYMÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.08.2014 EP 14179506**

(43) Veröffentlichungstag der Anmeldung:
**07.06.2017 Patentblatt 2017/23**

(73) Patentinhaber: **Covestro Deutschland AG**
**51373 Leverkusen (DE)**

(72) Erfinder:
- **FÄCKE, Thomas**
  **51375 Leverkusen (DE)**
- **BRUDER, Friedrich-Karl**
  **47802 Krefeld (DE)**
- **HÖNEL, Dennis**
  **53909 Zülpich-Wichterich (DE)**
- **WALZE, Günther**
  **51377 Leverkusen (DE)**
- **RÖLLE, Thomas**
  **51381 Leverkusen (DE)**

(74) Vertreter: **Levpat**
**c/o Covestro AG**
**Gebäude 4825**
**51365 Leverkusen (DE)**

(56) Entgegenhaltungen:
**EP-A1- 2 218 744**
**EP-A1- 2 613 319**
**EP-A1- 2 749 409**
**EP-A2- 1 968 057**
**WO-A1-2011/054797**
**WO-A1-2011/067057**
**JP-A- H04 214 340**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft einen Schichtaufbau umfassend eine Substratschicht und eine zumindest abschnittsweise mit der Substratschicht verbundene Photopolymerschicht. Weiterhin ist eine optische Anzeige Gegenstand der Erfindung, die einen erfindungsgemäßen Schichtaufbau umfasst.

Photopolymere stellen eine wichtige Klasse von Aufzeichnungmaterialien für Volumenhologramme dar. Bei der holographischen Belichtung wird das Interferenzfeld aus Signal- und Referenzlichtstrahl (im einfachsten Fall das zweier ebener Wellen) durch die lokale Photopolymerisation von z.B. hochbrechenden Acrylaten an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms allein mit dem Referenzlichtstrahl kann die Signalwellenfront wieder rekonstruiert werden. Die Stärke des so rekonstruierten Signals im Verhältnis zur Stärke des eingestrahlten Referenzlichts wird Beugungseffizienz, im folgenden DE wie Diffraction Efficiency, genannt.

Ebenfalls ist die Schichtdicke d des Photopolymers wichtig, dabei gilt je kleiner d ist desto größer ist die jeweilige Winkel- und Lichtfrequenzakzeptanzbreite. Will man helle und leicht sichtbare Hologramme herstellen, ist eine hohe Brechungsindexmodulation $\Delta n$ und eine geringe Dicke d anzustreben und zwar so, dass DE möglichst groß wird (P. Hariharan, Optical Holography, 2nd Edition, Cambridge University Press, 1996).

Volumenhologramme können nicht nur wie hinlänglich bekannt zur Herstellung von räumlich wirkenden Bildhologrammen genutzt werden, sondern eignen sich ebenfalls für optische Anwendungen. Dort wirken sie wie ein optisches Element mit dem man eine Wellenfront in eine bestimmte andere Wellenfront mittels diffraktiver Optik transformieren kann. Vorteilhaft ist die sehr elegante Möglichkeit die Funktionswinkel dieser optischen Elemente frei wählen zu können. So können mit sogenannten Transmissionshologrammen transmissive Geometrien (Eingangswellenfront auf der einen, Ausgangswellenfront auf der anderen Seite des holografischen Mediums) realisiert werden. In sogenannten Reflektionshologrammen liegen Eingangswellenfront und Ausgangswellenfront des optischen Elements auf der selben Seite des holografischen Mediums, sie wirken damit ähnlich wie ein Spiegel. Weiterhin gibt es Anwendungen, bei denen eine der beiden Wellenfronten sich im holografischen Medium bzw. in einer darunter in einer im optischen Kontakt befindlichen Lichtführungsschicht befindet, die andere aus dem Medium heraustritt. In diesem Fall spricht man von Edge-lit bzw. Waveguiding Hologrammen.

Neben der Wahl der Geometrie des holographisch optischen Elements kann die Wellenfronttransformation frei gewählt werden. Dies erfolgt durch die Auswahl einer entsprechenden Signal- und Referenzwellenform während der holographischen Belichtung.

Konzeptionell ist der Ansatz einer Wellenfronttransformation durch holographisch optischen Elemente höchst elegant, unterliegt in der Praxis aber auch den entsprechenden Anforderungen an eine optische Güte. Während in den bekannten räumlich darstellenden Bildhologrammen die Sensation der räumlichen Darstellung den Betrachter begeistert, sind in optisch technischen Anwendungen spezifische Abbildungsgüten der Optik von Relevanz. Derartige optische Elemente können in anspruchsvollen Anwendungen wie der Spektroskopie oder der Astronomie zum Einsatz kommen. Ebenso eignen sie sich zur Verwendung in elektronischen Displays, wie z.B. in 3D-Displays. Insbesondere bei abbildenden Optiken, in optischen Meßgeräten oder in Anwendungen in denen eine Null-Fehler Toleranz (z.B. bei Pixelfehlern in elektronischen Displays, in CCD-Kameras oder auch in Präzisionswerkzeugen) existiert, müssen die verwendeten Photopolymere als Aufzeichnungsmaterial diesen besonders hohen Anforderung genügen.

Ein Qualitätskriterium zur Beurteilung der Güte von optischen Instrumenten ist die Strehl-Zahl, oder kurz der "Strehl", der ein Verhältniswert aus experimenteller maximaler Intensität einer Punktlichtquelle in der Bildebene eines optischen Systems zur theoretischen maximalen Intensität desselben "perfekten" optischen Systems ergibt.

Weiterhin ist für die Beurteilung der optischen Güte die sogenannte RMS-Abweichungen (RMS = Root Mean Square") von Bedeutung, d.h. die erste Ableitung des Phasenprofils nach dem Ort entlang einer Linie. Für eine höhe optische Güte sollte der Wert möglichst klein sein.

Die Gesamtgüte eines Schichtaufbaus kann dann aus dem Quotienten aus Strehl geteilt durch die Ableitung des RMS Wertes bestimmt werden. Dieser Quotient entspricht damit der lateralen Länge der Oberfläche, um die Phasenlage um eine Wellenlänge zu ändern und wird nachfolgend Phasenreichweitenlänge P genannt.

$$P = \frac{\mathrm{Strehl}}{\frac{\mathrm{d\,RMS}}{\mathrm{d\,x}}}$$

Für gute Optiken benötigt man eine Phasenreichweitenlänge P von mindestens 0,8 cm/Wellenlänge, für sehr gute Optiken von mindestens 1,0 cm/Wellenlänge und für ausgezeichnete Optiken von mindestens 1,2 cm/Wellenlänge.

EP2749409A1 offenbart ein Sperrschichtlaminat und eine Gas-Sperrschichtfilm.

WO2011/067057A1 offenbart ein Verfahren zur Herstellung eines holographischen Films.

EP2613319A1 offenbart einen Schichtverbund aus einem Photopolymerfilm und einer Klebstoffschicht.

WO2011/054797A1 offenbart eine Photopolymerformulierung mit verschiedenen Schreibmonomeren.

EP2218744A1 offenbart eine Methode zur Herstellung von holographischen Photopolymeren und Polymerfilmen.

EP1968057A2 offenbart härtbare Zusammensetzungen.

JP H04 214340 offenbart einen Film für ein Flüssigkristalldisplay.

Aufgabe der vorliegenden Erfindung war es, einen Schichtaufbau der eingangs genannten Art bereitzustellen, der sich als Aufzeichnungsmedium für hochwertige holografisch optische Elemente eignet und dabei optische Güten aufweist, die eine Phasenreichweitenlänge P von mindestens 0,8 cm/Wellenlänge bevorzugt 1,0 cm/Wellenlänge und besonders bevorzugt 1,2 cm/Wellenlänge hat.

Diese Aufgabe ist durch einen Schichtaufbau umfassend eine Substratschicht und eine zumindest abschnittsweise mit der Substratschicht verbundene Photopolymerschicht gelöst, bei dem die Substratschicht eine durchschnittliche Retardation von $\leq$ 60 nm aufweist, wobei die Photopolymerschicht Matrixpolymere, Schreibmonomere und ein Photoinitiatorsystem umfasst.

So wurde überraschenderweise gefunden, dass Schichtaufbauten mit einer Substratschicht, die die erfindungsgemäß vorgesehene Retardation aufweisen, eine hohe optische Güte aufweisen. Dies erlaubt es beispielsweise in die Photopolymerschicht des Schichtaufbaus hochwertige holografisch optische Elemente einzubelichten.

Die Erfindung ist durch die angefügten Ansprüche definiert.

Gemäß einer ersten Ausführungsform kann die Substratschicht eine durchschnittliche Retardation von $\leq$ 40 nm und bevorzugt von $\leq$ 30 nm aufweisen. In diesem Fall eignen sich die Schichtaufbauten für optische Anwendungen mit besonders hoher Qualität.

Die durchschnittliche Retardation der Substratschicht kann bestimmt werden, indem mit einem bildgebenden Polarimetersystem, umfassend eine monochromatische LED-Lichtquelle, einen Polarisator, eine Meßprobe, eine Lambda-Viertel-Platte, einen Analysator und einen Detektor die Polarisationsebenendrehung $\alpha$ ortsaufgelöst gemessen und mittels der Messfrequenz $\lambda$ und der Formel $R = \alpha * \lambda/180°$ die ortaufgelöste Retardation R berechnet und anschließend über alle ortsaufgelöste Retardationswerte arithmetisch gemittelt wird. Die LED-Lichtquelle weist ein schmalbandiges Emissionsspektrum mit einer Halbwertbreite < 50 nm sowie eine maximale Emissionswellenlänge von $\lambda$ = 580 nm bis 595 nm auf.

Bei der Messung wird das linear polarisierte monochromatische LED-Licht der Lichtquelle durch die Substratschicht in elliptisch polarisiertes Licht und anschließend durch die Lambda-Viertel-Platte in linear polarisiertes Licht mit einer ggf. anderen Polarisationsebenenrichtung um den Winkel $\alpha$ zurückgewandelt. Mittels des Analysators und des Detektors kann dieser Winkel dann ortsaufgelöst bestimmt werden. Die Retardation R kann anschließend mittels der Beziehung

$$R = \frac{a \cdot \lambda}{180°}$$

in Nanometer [nm] errechnet werden. Für eine gegebene Position der Substratschicht erhält man bei einem bestimmen Winkel $\alpha$ die höchste Lichtintensität, die für diesen Ort dann die Retardation ergibt.

Bedingt durch das Meßprinzip mit einer bestimmten Meßachsenanordnung der Polarisationsebene des Lichters wird nun die Messung aus anderen Polarisationsebenen wiederholt. Typischerweise wird der Polarisator in 90° Schritten gedreht und die Messung jeweils wiederholt. Die Retardationsdaten werden nun aus den ortsbezogenenen Messungen gemittelt und man erhält so pro Position das abschließende Ergebnis der ortsabhängigen Messung.

Mit ortsabhängig ist jene Retardation gemeint, die durch das im Polarimetersystem befindliche Detektorsystem positionsgenau an der Substratschicht gemessen wurde. Der Meßbereich ist dabei 4 $mm^2$ bis 0,01 $mm^2$ groß, bevorzugt 0,5 $mm^2$ bis 0,02 $mm^2$ groß.

Nach der Messung wird über den gesamten Meßbereich die maximale und die durchschnittliche Retardation ermittelt. Gemäß einer weiteren bevorzugten Ausführungsform ist vorgesehen, dass die Substratschicht eine maximale (ortsaufgelöste) Retardation von $\leq$ 200 nm, bevorzugt von $\leq$ 100 nm und besonders bevorzugt von $\leq$ 50 nm aufweist.

Als Matrixpolymere können amorphe Thermoplaste wie z.B. Polyacrylate, Polymethylmethacrylate oder Copolymere von Methylmethacrylat, Methacrylsäure oder andere Alkylacrylate und Alkylmethacrylate sowie Acrylsäure, wie z.B. Polybutylacrylat, weiterhin Polyvinylacetat und Polyvinylburyrat seine partiell hydrolysierten Derivate wie Polyvinylalkohole sowie Copolymerisate mit Ethylene und/oder weiteren (Meth)acrylaten, Gelatine, Celluloseester und Celluloseether wie Methylcellulose, Celluloseacetobutyrat, Silikone, wie z.B. Polydimethylsilicon, Polyurethane, Polybutadiene und Polyisoprene, sowie Polyethylenoxide, Epoxyharze, insbesondere aliphatische Epoxyharze, Polyamide, Polycarbonate sowie die in US 4994347A und darin zitierten Systeme verwendet werden.

Die Matrixpolymere können insbesondere vernetzt und besonders bevorzugt dreidimensional vernetzt sein.

Besonders bevorzugt ist auch, wenn die Matrixpolymere Polyurethane umfassen oder daraus bestehen und ganz besonders bevorzugt ist, wenn die Matrixpolymere dreidimensional vernetzte Polyurethane umfassen oder daraus bestehen.

Derartige vernetzte Polyurethan-Matrixpolymere sind beispielsweise durch Umsetzung wenigstens einer Polyisocyanat-Komponente a) und wenigstens einer isocyanatreaktiven Komponente b) erhältlich.

Die Polyisocyanat-Komponente a) umfasst wenigstens eine organische Verbindung mit wenigstens zwei NCO-Gruppen. Bei diesen organischen Verbindungen kann es sich insbesondere um monomere Di- und Triisocyanate, Polyisocyanate und / oder NCO-funktionelle Prepolymere handeln. Die Polyisocyanat-Komponente a) kann auch Mischungen monomerer Di- und Triisocyanate, Polyisocyanate und / oder NCO-funktioneller Prepolymere enthalten oder daraus bestehen.

Als monomere Di- und Triisocyanate können alle dem Fachmann an sich gut bekannten Verbindungen oder deren Mischungen eingesetzt werden. Diese Verbindungen können aromatische, araliphatische, aliphatische oder cycloaliphatische Strukturen aufweisen. In untergeordneten Mengen können die monomeren Di- und Triisocyanate auch Monoisocyanate, d.h. organische Verbindungen mit einer NCO-Gruppe umfassen.

Beispiele für geeignete monomere Di- und Triisocyanate sind 1,4-Butandiisocyanat, 1,5-Pentandiisocyanat, 1,6-Hexandiisocyanat (Hexamethylendiisocyanat, HDI), 2,2,4-Trimethylhexamethylendiisocyanat und / oder 2,4,4-Trimethylhexamethylendiisocyanat (TMDI), Isophorondiisocyanat (IPDI), 1,8-Diisocyanato-4-(isocyanatomethyl)-octan, Bis-(4,4'-isocyanatocyclohexyl)methan und / oder Bis-(2',4-isocyanatocyclohexyl)methan und / oder deren Mischungen beliebigen Isomerengehalts, 1,4-Cyclohexandiisocyanat, die isomeren Bis-(isocyanatomethyl)cyclohexane, 2,4- und / oder 2,6-Diisocyanato-1-methylcyclohexan (Hexahydro-2,4- und / oder 2,6-toluylendiisocyanat, $H_6$-TDI), 1,4-Phenylendiisocyanat, 2,4- und / oder 2,6-Toluylendiisocyanat (TDI), 1,5-Naphthylendiisocyanat (NDI), 2,4'- und / oder 4,4'-Diphenylmethandiisocyanat (MDI), 1,3-Bis(isocyanatomethyl)benzol (XDI) und / oder das analoge 1,4-Isomere oder beliebige Mischungen der vorgenannten Verbindungen.

Geeignete Polyisocyanate sind Verbindungen mit Urethan-, Harnstoff-, Carbodiimid-, Acylharnstoff-, Amid-, Isocyanurat-, Allophanat-, Biuret-, Oxadiazintrion-, Uretdion- und/oder Iminooxadiazindionstrukturen, die aus den vorgenannten Di- oder Triisocyanaten erhältlich sind.

Besonders bevorzugt handelt es sich bei den Polyisocyanaten um oligomerisierte aliphatische und / oder cycloaliphatische Di- oder Triisocyanate, wobei insbesondere die oben stehenden aliphatischen und / oder cycloaliphatischen Di- oder Triisocyanate verwendet werden können.

Ganz besonders bevorzugt sind Polyisocyanate mit Isocyanurat-, Uretdion- und / oder Iminooxadiazindion-Strukturen sowie Biurete basierend auf HDI oder deren Mischungen.

Geeignete Prepolymere enthalten Urethan- und / oder Harnstoff-Gruppen sowie gegebenenfalls weitere durch Modifizierung von NCO-Gruppen entstandene Strukturen wie oben genannt. Derartige Prepolymere sind beispielsweise durch Umsetzung der oben genannten monomeren Di- und Triisocyanate und / oder Polyisocyanaten a1) mit isocyanatreaktiven Verbindungen b1) erhältlich.

Als isocyanatreaktive Verbindungen b1) können Alkohole, Amino oder MercaptoVerbindungen, bevorzugt Alkohole, verwendet werden. Dabei kann es sich insbesondere um Polyole handeln. Ganz besonders bevorzugt können als isocyanatreaktive Verbindung b1) Polyester-, Polyether-, Polycarbonat-, Poly(meth)acrylat- und/oder Polyurethan-Polyole verwendet werden.

Als Polyesterpolyole sind beispielsweise lineare Polyesterdiole oder verzweigte Polyesterpolyole geeignet, die in bekannter Weise durch Umsetzung von aliphatischen, cycloaliphatischen oder aromatischen Di- bzw. Polycarbonsäuren bzw. ihren Anhydriden mit mehrwertigen Alkoholen einer OH-Funktionalität $\geq 2$ erhalten werden können. Beispiele für geeignete Di- bzw. Polycarbonsäuren sind mehrwertige Carbonsäuren wie Bernstein-, Adipin-, Kork-, Sebacin-, Decandicarbon-, Phthal-, Terephthal-, Isophthal- Tetrahydrophthal- oder Trimellithsäure sowie Säureanhydride wie Phthal-, Trimellith- oder Bernsteinsäureanhydrid oder deren beliebige Gemische untereinander. Die Polyesterpolyole können auch auf natürlichen Rohstoffen wie Rizinusöl basieren. Es ist ebenfalls möglich, dass die Polyesterpolyole auf Homo- oder Mischpolymerisaten von Lactonen basieren, die bevorzugt durch Anlagerung von Lactonen bzw. Lactongemischen wie Butyrolacton, $\varepsilon$-Caprolacton und / oder Methyl-$\varepsilon$-caprolacton an hydroxyfunktionelle Verbindungen wie mehrwertige Alkohole einer OH-Funktionalität $\geq 2$ beispielsweise der nachstehend genannten Art erhalten werden können.

Beispiele für geeignete Alkohole sind alle mehrwertigen Alkohole wie z.B. die $C_2$-$C_{12}$-Diole, die isomeren Cyclohexandiole, Glycerin oder deren beliebige Gemische untereinander.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkohole einer OH-Funktionalität $\geq 2$, bevorzugt Butandiol-1,4, Hexandiol-1,6 und / oder 3-Methylpentandiol. Auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden. Besonders bevorzugt sind Propylenoxid-homopolymere sowie statistische oder Block-Copolymere, die Oxyethylen-, Oxypropylen- und / oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten $C_3$- und $C_4$-Isomere.

Daneben sind als Bestandteile der Polyol-Komponente b1) als polyfunktionelle, isocyanatreaktive Verbindungen auch niedermolekulare, d.h. mit Molekulargewichten ≤ 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise in Ergänzung zu den oben genannten Verbindungen Neopentylglykol, 2-Ethyl-2-butylpropandiol, Trimethylpentandiol, stellungs-isomere Diethyloctandiole, Cyclohexandiol, 1,4-Cyclohexandimethanol, 1,6-Hexandiol, 1,2- und 1,4-Cyclohexandiol, hydriertes Bisphenol A, 2,2-Bis(4-hydroxy-cyclohexyl)-propan oder 2,2-Dimethyl-3-hydroxypropionsäure, 2,2-dimethyl-3-hydroxypropyl-ester sein. Beispiele geeigneter Triole sind Trimethylolethan, Trimethylolpropan oder Glycerin. Geeignete höherfunktionelle Alkohole sind Di-(trimethylolpropan), Pentaerythrit, Dipenta-erythrit oder Sorbit.

Besonders bevorzugt ist, wenn die Polyolkomponente ein difunktioneller Polyether-, Polyester oder ein Polyether-polyester-block-copolyester oder ein Polyether-Polyester-Blockcopolymer mit primären OH-Funktionen ist.

Es ist ebenfalls möglich, als isocyanatreaktive Verbindungen b1) Amine einzusetzen. Beispiele geeigneter Amine sind Ethylendiamin, Propylendiamin, Diaminocyclohexan, 4,4'-Dicylohexylmethandiamin, Isophorondiamin (IPDA), difunktionelle Polyamine wie z.B. die Jeffamine®, aminterminierte Polymere, insbesondere mit zahlenmittleren Molmassen ≤ 10000 g/Mol. Mischungen der vorgenannten Amine können ebenfalls verwendet werden.

Es ist ebenfalls möglich, als isocyanatreaktive Verbindungen b1) Aminoalkohole einzusetzen. Beispiele geeigneter Aminoalkohole sind die isomeren Aminoethanole, die isomere Aminopropanole die isomeren Aminobutanole und die isomeren Aminohexanole oder deren beliebige Mischungen.

Alle vorgenannten isocyanatreaktiven Verbindungen b1) können untereinander beliebig vermischt werden.

Bevorzugt ist auch, wenn die isocyanatreaktiven Verbindungen b1) eine zahlenmittlere Molmasse von ≥ 200 und ≤ 10000 g/Mol, weiter bevorzugt ≥ 500 und ≤ 8000 g/Mol und ganz besonders bevorzugt ≥ 800 und ≤ 5000 g/Mol aufweisen. Die OH-Funktionalität der Polyole beträgt bevorzugt 1.5 bis 6.0, besonders bevorzugt 1.8 bis 4.0.

Die Prepolymere der Polyisocyanat-Komponente a) können insbesondere einen Restgehalt an freiem monomeren Di- und Triisocyanaten < 1 Gew.-%, besonders bevorzugt < 0.5 Gew.-% und ganz besonders bevorzugt < 0.3 Gew.-% aufweisen.

Es ist gegebenenfalls auch möglich, dass die Polyisocyanat-Komponente a) vollständig oder anteilsmäßig organische Verbindung enthält, deren NCO-Gruppen ganz oder teilweise mit aus der Beschichtungstechnologie bekannten Blockierungsmitteln umgesetzt sind. Beispiel für Blockierungsmittel sind Alkohole, Lactame, Oxime, Malonester, Pyrazole sowie Amine, wie z.B. Butanonoxim, Diisopropylamin, Malonsäurediethylester, Acetessigester, 3,5-Dimethylpyrazol, ε-Caprolactam, oder deren Mischungen.

Besonders bevorzugt ist, wenn die Polyisocyanat-Komponente a) Verbindungen mit aliphatisch gebundenen NCO-Gruppen umfasst, wobei unter aliphatisch gebundenen NCO-Gruppen derartige Gruppen verstanden werden, die an ein primäres C-Atom gebunden sind.

Die isocyanatreaktive Komponente b) umfasst bevorzugt wenigstens eine organische Verbindung, die im Mittel wenigstens 1.5 und bevorzugt 2 bis 3 isocyanatreaktive Gruppen aufweist. Im Rahmen der vorliegenden Erfindung werden als isocyanatreaktive Gruppen bevorzugt Hydroxy-, Amino- oder Mercapto-Gruppen angesehen.

Die isocyanatreaktive Komponente kann insbesondere Verbindungen umfassen, die im Zahlenmittel wenigstens 1.5 und bevorzugt 2 bis 3 isocyanatreaktive Gruppen aufweisen. Geeignete polyfunktionelle, isocyanatreaktive Verbindungen der Komponente b) sind beispielsweise die oben beschriebenen Verbindungen b1).

Bei den Schreibmonomeren kann es sich um Verbindungen handeln, die photoinitiert polymersierbar sind. Dies sind kationisch und anionisch polymerisierbare sowie radikalisch polymerisierbare Verbindungen. Besonders bevorzugt sind radikalisch polymerisierbare Verbindungen. Beispiele für geeigenete Verbindungsklassen sind ungesättigte Verbindungen wie (Meth)-Acrylate, α,β-ungesättigte Carbonsäurederivate wie beispielsweise Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol und / oder Olefine. Weiterhin können auch Thio-En reaktive Verbindungen also z.B. Thiole und activierte Doppelbindungen radikalisch polymerisiert werden.

Beispiele bevorzugt verwendbarer (Meth)-Acrylate sind Phenylacrylat, Phenylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Bisphenol A Diacrylat, Bisphenol A Dimethacrylat, sowie deren ethoxylierte Analogverbindungen, N-Carbazolylacrylate.

Besonders bevorzugt können auch Urethan-(meth)-acrylate als Schreibmonomere verwendet werden.

Ganz besonders bevorzugt ist, wenn die Schreibmonomere ein oder mehrere Urethan-(meth)-acrylate umfassen oder daraus bestehen.

Als Urethan-(meth)-acrylate werden vorliegend Verbindungen mit mindestens einer Acrylsäureestergruppe bzw. Methacrylsäuregruppe und mindestens eine Urethanbindung verstanden. Solche Verbindungen können beispielsweise durch Umsetzung eines Hydroxyfunktionellen (Meth)-acrylats mit einer Isocyanat-funktionellen Verbindung erhalten werden.

Beispiele hierfür verwendbarer Isocyanat-funktionelle Verbindungen sind Monoisocyanate sowie die unter a) genannten monomeren Diisocyanate, Triisocyanate und / oder Polyisocyanate. Beispiele geeigneter Monoisocyanate sind Phenylisocyanat, die isomeren Methylthiophenylisocyanate. Di-, Tri- oder Polyisocyanate sind oben genannt sowie Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle (Meth)-Acrylate für die Herstellung von Urethanacrylaten kommen beispielsweise Verbindungen wie 2-Hydroxyethyl(meth)-acrylat, Polyethylenoxid-mono-(meth)acrylate, Polypropylenoxidmono-(meth)-acrylate, Polyalkylenoxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono-(meth)-acrylat.

Ebenfalls verwendet werden können die an sich bekannten hydroxylgruppenhaltigen Epoxy-(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester-(meth)-acrylaten oder Mischungen hydroxylgruppenhaltiger ungesättigter Polyester mit Polyester(meth)acrylaten.

Bevorzugt sind insbesondere Urethan-(meth)-acrylate erhältlich aus der Umsetzung von Tris(p-isocyanatophenyl)thiophosphat und / oder m-Methylthiophenylisocyanat mit alkoholfunktionellen Acrylaten wie Hydroxyethyl-(meth)-acrylat, Hydroxypropyl-(meth)-acrylat und / oder Hydroxybutyl(meth)acrylat.

Bevorzugt ist auch, wenn als Schreibmonomere Verbindungen eingesetzt werden, die zwei oder mehr radikalisch polymerisierbare Gruppen pro Molekül aufweisen (multifunktionelle Schreibmonomere). Diese können allein oder in Kombination mit Schreibmonomeren, die nur eine radikalisch polymerisierbare Gruppe pro Molekül aufweisen, eingesetzt werden.

Bevorzugt können die Schreibmonomere daher auch wenigstens ein mono- und / oder ein multifunktionelles (Meth)-acrylat-Schreibmonomer umfassen oder daraus bestehen. Besonders bevorzugt ist, wenn die Schreibmonomere wenigstens ein mono- und / oder ein multifunktionelles Urethan-(meth)-acrylat umfassen oder daraus bestehen. Ganz besonders bevorzugt ist, wenn die Schreibmonomere wenigstens ein monofunktionelles Urethan-(meth)-acrylat und wenigstens ein multifunktionelles Urethan-(meth)-acrylat umfassen oder daraus bestehen

Geeignete (Meth)-acrylat-Schreibmonomere sind insbesondere Verbindungen der allgemeinen Formel (I)

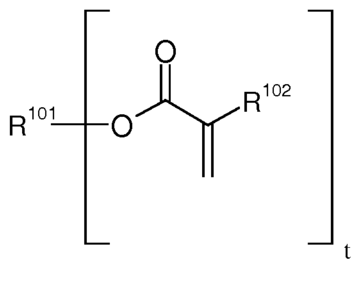

(I)

bei denen t≥1 und t≤4 ist und $R^{101}$ ein linearer, verzweigter, cyclischer oder heterocyclischer unsubstituierter oder gegebenenfalls auch mit Heteroatomen substituierter organischer Rest und/oder $R^{102}$ Wasserstoff, ein linearer, verzweigter, cyclischer oder heterocyclischer unsubstituierter oder gegebenenfalls auch mit Heteroatomen substituierter organischer Rest ist. Besonders bevorzugt ist $R^{102}$ Wasserstoff oder Methyl und/oder $R^{101}$ ein linearer, verzweigter, cyclischer oder heterocyclischer unsubstituierter oder gegebenenfalls auch mit Heteroatomen substituierter organischer Rest.

Das Photoinitiatorsystem umfasst wenigstens einen Photoinitiator.

Photoinitiatoren sind vorliegend durch aktinische Strahlung aktivierbare Verbindungen, die eine Polymerisation der Schreibmonomere auslösen können. Bei den Photoinitiatoren kann zwischen unimolekularen (Typ I) und bimolekularen (Typ II) Initiatoren unterschieden werden. Des Weiteren werden sie je nach ihrer chemischen Natur in Photoinitiatoren für radikalische, anionische, kationische oder gemischte Art der Polymerisation unterschieden.

Typ I-Photoinitiatoren (Norrish-Typ-I) für die radikalische Photopolymerisation bilden beim Bestrahlen durch eine unimolekulare Bindungsspaltung freie Radikale. Beispiele für Typ I-Photoinitiatoren sind Triazine, Oxime, Benzoinether, Benzilketale, Bis-imidazole, Aroylphosphinoxide, Sulfonium- und Iodoniumsalze.

Typ II-Photoinitiatoren (Norrish-Typ-II) für die radikalische Polymerisation bestehen aus einem Farbstoff als Sensibilisator und einem Coinitiator und durchlaufen bei der Bestrahlung mit auf den Farbstoff angepasstem Licht eine bimolekulare Reaktion. Zunächst absorbiert der Farbstoff ein Photon und überträgt aus einem angeregten Zustand Energie auf den Coinitiator. Dieser setzt durch Elektronen- oder Protonentransfer oder direkte Wasserstoffabstraktion die polymerisationsauslösenden Radikale frei.

Im Sinne dieser Erfindung werden bevorzugt Typ II-Photoinitiatoren verwendet. Daher ist bei einer bevorzugten Ausführungsform vorgesehen, dass das Photoinitiatorsystem aus einem im sichtbaren spektralen Bereich absorbierenden Sensibilisator und einem Coinitiator besteht, wobei der Coinitiator bevorzugt ein Borat-Coinitiator sein kann.

Solche Photoinitiatoren sind prinzipiell in der EP 0 223 587 A beschriebenen und bestehen bevorzugt aus einer Mischung von einem oder mehreren Farbstoffen mit Ammoniumalkylarylborat(en).

Geeignete Farbstoffe, die zusammen mit einem Ammoniumalkylarylborat einen Typ II-Photoinitiator bilden, sind die in der WO 2012062655 beschriebenen kationischen Farbstoffe in Kombination mit den eben dort beschriebenen Anionen.

Unter kationischen Farbstoffen werden bevorzugt solche der folgenden Klassen verstanden: Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Besonders bevorzugt sind Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di-, Tri- und Pentamethincyanin-Farbstoffe, Hemicyanin-Farbstoffe, Nullmethin-Farbstoffe - insbesondere Naphtholactam-Farbstoffe, Streptocyanin-Farbstoffe.

Beispiele für kationische Farbstoffe sind Astrazon Orange G, Basic Blue 3, Basic Orange 22, Basic Red 13, Basic Violett 7, Methylenblau, Neu Methylenblau, Azur A, 2,4-Diphenyl-6-(4-methoxyphenyl)pyrylium, Safranin O, Astraphloxin, Brilliant Grün, Kristallviolett, Ethylviolett und Thionin.

Bevorzugte Anionen sind insbesondere $C_8$- bis $C_{25}$-Alkansulfonat, vorzugsweise $C_{13}$- bis $C_{25}$-Alkansulfonat, $C_3$- bis $C_{18}$-Perfluoralkansulfonat, $C_4$- bis $C_{18}$-Perfluoralkansulfonat, das in der Alkylkette mindestens 3 Wasserstoffatome trägt, $C_9$- bis $C_{25}$-Alkanoat, $C_9$- bis $C_{25}$-Alkenoat, $C_8$- bis $C_{25}$-Alkylsulfat, vorzugsweise $C_3$- bis $C_{25}$-Alkylsulfat, $C_8$- bis $C_{25}$-Alkenylsulfat, vorzugsweise $C_{13}$- bis $C_{25}$-Alkenylsulfat, $C_3$- bis $C_{18}$-Perfluoralkylsulfat, $C_4$-bis $C_{18}$-Perfluoralkylsulfat, das in der Alkylkette mindestens 3 Wasserstoffatome trägt, Polyethersulfate basierend auf mindestens 4 Äquivalenten Ethylenoxid und/oder Äquivalenten 4 Propylenoxid, Bis-$C_4$- bis $C_{25}$-Alkyl-, $C_5$- bis $C_7$-Cycloalkyl-, $C_3$- bis $C_8$-Alkenyl- oder $C_7$- bis $C_{11}$-Aralkyl-sulfosuccinat, durch mindestens 8 Fluoratome substituiertes Bis-$C_2$- bis $C_{10}$-alkyl-sulfosuccinat, $C_8$- bis $C_{25}$-Alkyl-sulfoacetate, durch mindestens einen Rest der Gruppe Halogen, $C_4$- bis $C_{25}$-Alkyl, Perfluor-$C_1$- bis $C_8$-Alkyl und/oder $C_1$- bis $C_{12}$-Alkoxycarbonyl substituiertes Benzolsulfonat, ggf. durch Nitro, Cyano, Hydroxy, $C_1$- bis $C_{25}$-Alkyl, $C_1$- bis $C_{12}$-Alkoxy, Amino, $C_1$- bis $C_{12}$-Alkoxycarbonyl oder Chlor substituiertes Naphthalin- oder Biphenylsulfonat, ggf. durch Nitro, Cyano, Hydroxy, $C_1$- bis $C_{25}$-Alkyl, $C_1$- bis $C_{12}$-Alkoxy, $C_1$- bis $C_{12}$-Alkoxycarbonyl oder Chlor substituiertes Benzol-, Naphthalin- oder Biphenyldisulfonat, durch Dinitro, $C_6$- bis $C_{25}$-Alkyl, $C_4$- bis $C_{12}$-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte $C_8$- bis $C_{25}$-Fettsäureester von aliphatischen $C_1$- bis Cs-Alkoholen oder Glycerin, Bis-(sulfo-$C_2$- bis $C_6$-alkyl)-$C_3$- bis $C_{12}$-alkandicarbonsäureester,

Bis-(sulfo-$C_2$- bis $C_6$-alkyl)-itaconsäureester, (Sulfo-$C_2$- bis $C_6$-alkyl)-$C_6$- bis $C_{18}$-alkancarbonsäureester, (Sulfo-$C_2$- bis $C_6$-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, $C_4$- bis $C_{12}$-Alkyl-triphenylborat, deren Phenyl- oder Phenoxy-Reste durch Halogen, $C_1$- bis $C_4$-Alkyl und/oder $C_1$- bis $C_4$-Alkoxy substituiert sein können, $C_4$- bis $C_{12}$-Alkyl-trinaphthylborat, Tetra-$C_1$- bis $C_{20}$-alkoxyborat, 7,8- oder 7,9-Dicarba-nido-undecaborat(1-) oder (2-), die gegebenenfalls an den B- und/oder C-Atomen durch eine oder zwei $C_1$- bis $C_{12}$-Alkyl- oder Phenyl-Gruppen substituiert sind, Dodecahydrodicarbadodecaborat(2-) oder B-$C_1$- bis $C_{12}$-Alkyl-C-phenyl-dodecahydrodicarbadodecaborat(1-) steht, wobei bei mehrwertigen Anionen wie Naphthalindisulfonat $A^-$ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl substituiert sein können.

Bevorzugt ist auch, wenn das Anion $A^-$ des Farbstoffs einen AClogP im Bereich von 1 bis 30, besonders bevorzugt im Bereich von 1 bis 12 und insbesondere bevorzugt im Bereich von 1 bis 6,5 aufweist. Der AClogP wird nach J. Comput. Aid. Mol. Des. 2005, 19, 453; Virtual Computational Chemistry Laboratory, http://www.vcclab.org berechnet.

Geeignete Ammoniumalkylarylborate sind beispielsweise (Cunningham et al., RadTech'98 North America UV/EB Conference Proceedings, Chicago, Apr. 19-22, 1998): Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat hexylborat ([191726-69-9], CGI 7460, Produkt der BASF SE, Basel, Schweiz), 1-Methyl-3-octylimidazolium Dipentyldiphenylborat und Tetrabutylammonium Tris-(3-chlor-4-methylphenyl)-hexylborat ([1147315-11-4], CGI 909, Produkt der BASF SE, Basel, Schweiz).

Das Photoinitiatorsystem kann auch Gemische von Photoinitiatoren enthalten. Je nach verwendeter Strahlungsquelle kann Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Ganz besonders bevorzugt ist, wenn das Photoinitiatorsystem eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bevorzugt ist auch, wenn wenigstens ein für eine Laserlichtfarbe ausgewählt aus blau, grün und rot geeigneter Photoinitiator in dem Photoinitiatorsystem enthalten ist.

Weiter bevorzugt ist auch, wenn das Photoinitiatorsystem für wenigstens zwei Laserlichtfarben ausgewählt aus blau, grün und rot je einen geeigneten Photoinitiator enthält.

Ganz besonders bevorzugt ist schließlich, wenn das Photoinitiatorsystem für jede der Laserlichtfarben blau, grün und rot jeweils einen geeigneten Photoinitiator enthält.

Gemäß einer weiteren bevorzugten Ausführungsform ist vorgesehen, dass die Photopolymerschicht Fluorurethane umfasst wobei diese bevorzugt Verbindungen gemäß der Formel (II) sein können

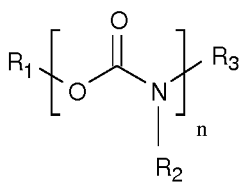

(II)

in der n≥1 und n≤8 ist und $R_1$, $R_2$, $R_3$ unabhängig voneinander Wasserstoff, lineare, verzweigte, cyclische oder heterocyclische unsubstituierte oder gegebenenfalls auch mit Heteroatomen substituierte organische Reste sind, wobei mindestens einer der Reste $R_1$, $R_2$, $R_3$ mit wenigstens einem Fluoratom substituiert ist und besonders bevorzugt $R_1$ ein organischer Rest mit mindestens einem Fluoratom ist.

Die Photopolymerschicht kann zusätzlich auch einen oder mehrere Radikalstabilisatoren, enthalten.

Als Radikalstabilisatoren können beispielsweise die in "Methoden der organischen Chemie" (Houben-Weyl), 4. Auflage, Band XIV/1, S. 433ff, Georg Thieme Verlag, Stuttgart 1961, be¬schrie¬ben Verbindungen verwendet werden. Geeignete Stoffklassen sind beispielsweise Phenole, Kresole, p-Methoxyphenole, p-Alkoxyphenole, Hydrochinone, Benzylalkohole wie z.B. Benzhydrol, Chinone wie z. B. 2,5-Di-tert.-Butylchinon, aromatische Amine wie Diisopropylamin oder Phenothiazin sowie HALS-Amine.

Als phenolische Stabilisatoren eignen sich beispielsweise:

Ortho-t.Butyl-phenole wie z.B. Ethylene bis[3,3-bis(3-tert-butyl-4-hydroxyphenyl)butyrat]; 1,1,3-Tris(2'-methyl-4'-hydroxy-5'-tert.butylphenyl)butan; 1,3,5-Tris (4-tert.-butyl-3-hydroxy-2,6-dimethylbenzyl)-1,3,5-triazin-2,4,6-(1H,3H,5H)-trion;

Bis-ortho.t.butyl-phenole wie z.B. 2,6-Di-tert-butyl-4-methylphenol, Ester von mono-, di-, tri-, tetra- penta- und hexavalenten Alkoholen mit 3,5-Di-tert-butyl-4-hydroxyphenylpropionsäure, wie z.B. mit Pentaerythrol als Pentaerythritol tetrakis(3-(3,5-di-tert-butyl-4-hydroxyphenyl)propionat), mit Oktylalkohol wie Octadecyl-3-(3,5-di-tert-butyl-4-hydroxyphenyl)propionat und dergleichen;

Phenolische Oligomere mit Bis-ortho-tert-butyl-phenolgruppen wie z.B. 1,3,5-Trimethyl-2,4,6-tris(3,5-di-tert-butyl-4-hydroxybenzyl)benzol; Tris(3,5-di-tert-butyl-4-hydroxybenzyl) isocyanurat, Triethyleneglycol-bis[3-(3-tert.butyl-4-hydroxy-5-methylphenyl)propionat]; N,N'-Hexamethylene bis[3-(3,5-di-tert.butyl-4-hydroxyphenyl)propionamid; 2,2'-Methylenebis[4-methyl-6-(1-methylcyclohexyl)phenol];

Sterisch gehinderte Phenole, wie z.B. 2,2'-Ethylidenebis[4,6-di-tert.butylphenol], 2,2'-Methylenebis(6-tert.butyl-4-methylphenol), 4,4'-Butylidenebis(2-tert.butyl-5-methylphenol), 2,2'-Isobutylidenebis(4,6-dimethylphenol) und andere sterisch gehinderte Phenole, wie z.B. C7-9-verzweigte Alkyl ester der 3,5-bis(1,1-dimethylethyl)-4-hydroxy-Phenylpropansäure.

Als sterisch gehinderte Amine (sogenannte HALS-Amine) eignen sich beispielsweise:

2,2,6,6-Tetramethyl-4-piperidinyl-octadecansäurester; 1-Methyl 10-(1,2,2,6,6-pentamethyl-4-piperidinyl)-decanedisäurediester; 3-dodecyl-1-(2,2,6,6-tetramethyl-4-piperidinyl)-2,5-pyrrolidinedion; N,N'-Bisformyl-N,N'-bis-(2,2,6,6-tetramethyl-4-piperidinyl)-hexamethylendiamin; Bis-(2,2,6,6-tetramethyl-4-piperidyl)-sebacat; 1,10-Bis(1,2,2,6,6-pentamethyl-4-piperidinyl)-decanedisäurediester; 1,3:2,4-Bis-O-(2,2,6,6-tetramethyl-4-piperidinylidene)-D-Glucitol; 1,1'-(1,2-Ethanediyl)bis[3,3,5,5-tetramethyl-2-Piperazinon]; Poly[[6-[(1,1,3,3-tetramethylbutyl)amino]-s-triazin-2,4-diyl]-[(2,2,6,6-tetramethyl-4-piperidyl)imino]-hexamethylen-[(2,2,6,6-tetramethyl-4-piperidyl)imino; Poly[[6-(4-morpholinyl)-1,3,5-triazin-2,4-diyl] [(2,2,6,6-tetramethyl-4-piperidinyl)imino]-1,6-hexanediyl[(2,2,6,6-tetramethyl-4-piperidinyl)imino]]; 2,2,4,4-Tetramethyl-20-(2-oxiranylmethyl)-7-Oxa-3,20-diazadispiro[5.1.11.2]heneicosan-21-one; 1,1',1''-[1,3,5-Triazine-2,4,6-triyltris[(cyclohexylimino)-2,1-ethanediyl]]tris[3,3,5,5-tetramethyl-piperazinon; Homo- und Copolymerisate des N-(2,2,6,6-Tetramethyl-4-piperidinyl)-maleinimid mit endständigen Olefinen und/oder Alkylacrylaten; (Poly)ester des 4-Hydroxy-2,2,6,6-tetramethyl-1-piperidineethanols mit Carbonsäuren, insbesondere auch mit Dicarbonsäuren zu Polymeren wie z.B. Poly(4-hydroxy-2,2,6,6-tetramethyl-1-piperidineethanolalt-1,4-butandisäure);

N-alkylsubstituierte sterisch gehinderte Amine wie z.B. 3-Dodecyl-1-(1,2,2,6,6-pentamethyl-4-piperidinyl)- 2,5-Pyrrolidinedion; Bis-(1,2,2,6,6-pentamethyl-4-piperidyl)-sebacat; Methyl-(1,2,2,6,6-pentamethyl-4-piperidyl)-sebacat; 1-(Methyl)-8-(1,2,2,6,6-pentamethyl-4-piperidinyl)-sebacate; 1,10-bis(1,2,2,6,6-pentamethyl-4-piperidinyl) Decanedisäurediester; 1,1',1''-[1,3,5-triazine-2,4,6-triyltris[(cyclohexylimino)-2,1-ethanediyl]]tris[3,3,4,5,5-pentamethyl-2-piperazinon;

N-Oxylsubstituierte sterisch gehinderte Amine wie z.B. Bis(1-oxyl-2,2,6,6,-tetramethylpiperidin-4-yl)sebacate;

Alkoxysubstituierte sterisch gehinderte Amine wie z.B. 1,10-bis(1- Octyloxy-2,2,6,6-tetramethyl-4-piperidinyl) decanedisäurediester;

Acetyl-substituierte sterische gehinderte Amine wie z.B. 1N-(1-acetyl-2,2,6,6-tetramethyl-4-piperidinyl)-2N-dodecylethandiamide;

Wahlweise unsubstituierte, N-alkylsubstituierte, N-acylsubstituierte, N-oxylsubstituiert sterisch gehinderte Amine, die mit phenolischen Stabilisatorgruppen in einem Molekül kombiniert vorliegen, wie z.B. Bis(1,2,2,6,6-pentamethyl-4-piperidyl)-[[3,5-bis(1,1-dimethylethyl)-4-hydroxyphenyl]methyl]butylmalonate.

Bevorzugte Radikalstabilisatoren sind 2,6-Di-tert.-butyl-4-methylphenol, p-Methoxyphenol, 1,10-Bis(1,2,2,6,6-pentamethyl-4-piperidinyl)-decanedisäurediester; 1-Methyl 10-(1,2,2,6,6-pentamethyl-4-piperidinyl)-decanedisäurediester.

Besonders bevorzugt ist, wenn die Photopolymerschicht mehrere unterschiedliche Stabilisatoren wie z. B. einen phenolischen Stabilisator und ein sterisch gehindertes Amin, enthält.

Ebenfalls besonders bevorzugt ist, wenn die Photopolymerschicht 0,001 bis 2 Gew.-%, weiter bevorzugt 0,001 bis 1,5 und besonders bevorzugt 0,01 bis 1,0 Gew.-% eines oder mehrerer, bevorzugt aber mehrerer Radikalstabilisatoren enthält.

Gegebenenfalls kann die Photopolymerschicht auch einen oder mehrere Katalysatoren enthalten. Dabei kann

es sich insbersondere um Katalysatoren zur Beschleunigung der Urethanbildung handeln. Beispiele hierfür sind Zinnoctoat, Zinkoktoat, Butylzinntrisoctoat, Dibutylzinndilaurat, Dimethylbis[(1-oxoneodecyl)oxy]stannan, Dimethylzinndicarboxylat, Zirkonium-bis(ethylhexanoat), Zirconium-acteylacetonat oder tertiäre Aminen wie beispielsweise 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Butylzinntrisoctoat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Die Photopolymerschicht kann auch weitere Hilfs- oder Zusatzstoffe enthalten. Dabei kann es sich beispielsweise um Lösemittel, Weichmacher, Verlaufsmittel oder Haftvermittler handeln. Es kann auch von Vorteil sein, gleichzeitig mehrere Zusatzstoffe eines Typs oder verschiedener Typen zu verwenden.

Zur Herstellung der Photopolymerschicht kann das Photopolymer beispielsweise mit Hilfe einer Rollenbeschichtungsanlage auf die Substratschicht aufgebracht werden.

Dies ist durch eine Kombination verschiedener Prozessschritte möglich, bei denen dem Fachmann bekannte Zwangsdosierpumpen, Vakuumentgaser, Plattenfilter, Statische Mischer, Schlitzdüsen oder verschiedene Rakelsysteme, Ein-Rollenabwickler, Lufttrockner, Trockenkaschiereinrichtung und eine Ein-Rollenaufwickeleinrichtung, eingesetzt werden können. Speziell Beschichtungseinrichtungen, die z.B. Schlitzdüsen und Rakelsysteme aufweisen, sind für die Applikation von flüssigen Photopolymeren auf Substratschichten geeignet und zeichnen sich durch eine hohe Genauigkeit in der Applikationsschichtdicke aus.

Die Bestandteile des Photopolymers können als zwei separate Komponenten einer Beschichtungsanlage zugeführt, dort gemischt und dann auf die Substratschicht appliziert werden. Dies ist insbesondere dann vorteilhaft, wenn die Matrixpolymere Polyurethane sind, die wie oben beschrieben durch Umsetzung wenigstens einer Polyisocyanat-Komponente a) und wenigstens einer isocyanatreaktiven Komponente b) hergestellt werden können. In diesem Fall kann in der ersten Komponente eine Polyisocyanat-Komponente a) und in der zweiten Komponente eine isocyanatreaktive Komponente b) enthalten sein. Weitere Bestandteile des Photopolymers wie z.B. Schreibmonomere, Photoinitiatoren, Radikalstabilisatoren, Fluorurethane, Lösemittel und Additive können dann sowohl ganz oder jeweils in Teilen in der ersten Komponente oder der zweiten Komponente enthalten sein. Wenn das Photoinitiatorsystem wenigstens einen Farbstoff und einen darauf abgestimmten Coninitator umfasst, kann es auch vorteilhaft sein, wenn der Farbstoff und der Coninitiator in jeweils einer der beiden Komponenten enthalten sind.

Gemäß einer weiteren bevorzugten Ausführungsform des erfindungsgemäßen Schichtaufbaus ist vorgesehen, dass die Substratschicht in dem Wellenlängenbereich von 410 bis 780 nm eine Mindesttransmission $\geq$ 70% aufweist. Die Transmission einer Substratschicht wird in einem UV-VIS Spektrometer in Transmissionsgeometrie gemäß DIN 5036 im spektralen Bereich von 410 bis 780 nm wellenlängenabhängig ermittelt. Als Mindesttransmission wird der kleinste dabei wellenlängenabhängig ermittelte Transmissionswert definiert. Gemäß einer weiteren bevorzugten Ausführungsform weist die Substratschicht eine Mindesttransmission von $\geq$ 75% und besonders bevorzugt von $\geq$ 80% auf.

In einer weiteren bevorzugten Ausführungsform ist vorgesehen, dass die Substratschicht eine essentiell elastische Dehnung von maximal 0,2% bei einer Substratbreite von einem Meter bei einer Zugkraft von mindestens 80 Newton, bevorzugt von mindestens 110 Newton und besonders bevorzugt von mindestens 140 Newton aufweist. Die elastische Dehnung wird in einem Zugversuch nach EN ISO 527-1 ermittelt.

Die Substratschicht kann beispielsweise aus Polycarbonat, Polyester, Polyethylen, Polypropylen, Celluloseacetat, Cellulosenitrat, Cycloolefinpolymer, Polystyrol, Styrol-Acrylat-Copolymer, Polysulfon, Cellulosetriacetat, Polyamid, Polymethylmethacrylat, Polyvinylchlorid, Copolymeren des Styrols mit Alkyl(meth)acrylaten/Etylen/Propylen, Polyvinylbutyral, Polydicyclopentadien aufgebaut sein. Besonders vorteilhaft sind jedoch Substratschichten aus Polycarbonaten (z.B. Polycarbonaten des Bisphenol A, Bisphenol C), amorphen und semikristallinen Polyamiden, amorphen und semikristallinen Polyestern, sowie Cellulosetriacetaten.

Die Substratschicht kann einseitig oder beidseitig antihaftend, antistatisch, hydrophobiert oder hydrophiliert ausgerüstet sein. Eine Modifikationen auf der der Photopolymerschicht zugewandten Seite können dem Zweck dienen, ein zerstörungsfreies Ablösen der Photopolymerschicht von der Substratschicht zu ermöglichen. Eine Modifikation auf der der Photopolymerschicht abgewandten Seite der Substratschicht kann dafür sorgen, dass der erfindungsgemäße Schichtverbund speziellen mechanischen Anforderungen genügtt, die z.B. bei der Verarbeitung in Rollenlaminatoren, insbesondere beim Rolle-zu-Rolle-Verfahren, gefordert sind.

Gemäß einer weiteren bevorzugten Ausführungsform ist vorgesehen, dass der Betrag der Differenz des Brechungsindexes der Substratschicht (gemessen gemäß DIN EN ISO 489 bei 589,3 nm) und der Photopolymerschicht (bestimmt durch Anpassung des spektralen Verlaufs von n an das visuelle Transmissions- und Reflexionsspektrum und angegeben für 589,3 nm) $\leq$ 0,075 bevorzugt $\leq$ 0,065 und besonders bevorzugt $\leq$ 0,050 ist. So ist es insbesondere in speziellen Optikaufbauten wie Edge-Lit Hologrammen und Waveguiding Hologrammen besonders vorteilhaft den Betrag der Differenz des Brechungsindexes der Substratschicht und der Photopolymerschicht möglichst klein zu halten.

Ebenfalls bevorzugt ist, wenn die Substratschicht und die Photopolymerschicht vollflächig miteinander verbunden sind.

Die Substratschicht kann eine Dicke von 10 bis 250 μm, bevorzugt von 20 bis 180 μm und besonders bevorzugt von 35 bis 150 μm und / oder die Photopolymerschicht eine Dicke von 0,5 bis 200 μm und bevorzugt von 1 bis 100 μm aufweisen.

Bei einer weiteren bevorzugten Ausführungsform des erfindungsgemäßen Schichtaufbaus ist in die Photopolymerschicht wenigstens ein Hologramm einbelichtet.

Insbesondere kann das Hologramm ein Reflektions-, Transmissions-, In-Line-, Off-Axis-, Full-Aperture Transfer-, Weißlicht-Transmissions-, Denisyuk-, Off-Axis Reflektions- oder Edge-Lit Hologramm sowie ein holographisches Stereogramm und bevorzugt ein Reflektions-, Transmissions- oder Edge-Lit Hologramm sein.

Mögliche optische Funktionen der Hologramme entsprechen den optische Funktionen von Lichtelementen wie Linsen, Spiegel, Umlenkspiegel, Filter, Streuscheiben, gerichteten Streuelementen, gerichtete holografische Diffusoren, Beugungselemente, Lichtleiter, Lichtlenker (waveguides), Ein- bzw. Auskoppelelementen, Projektionsscheiben und/oder Masken. Zudem können mehrere derartiger optischer Funktionen in einem solchen Hologramm kombiniert werden, z.B. so dass je nach Lichteinfall das Licht in eine andere Richtung abgebeugt wird. So kann man beispielweise mit derartigen Aufbauten autostereoskopische oder holografische elektronische Displays bauen, die es erlauben einen stereoskopischen bzw. holografischen visuellen Eindruck ohne weitere Hilfsmittel wie z.B. einer Polarisator- oder Shutterbrille zu erleben. Weiter ist es möglich automobile Head-up Displays oder Head-mounted Displays zu realisieren. So ist es ebenfalls möglich die erfindungsgemäßen Schichtaufbauten in Korrektur- oder Sonnenbrillen verwendet werden.

Häufig zeigen diese optischen Elemente eine spezifische Frequenzselektivität, je nachdem wie die Hologramme belichtet wurden und welche Dimensionen das Hologramm hat. Dies ist insbesondere wichtig, wenn man monochromatische Lichtquellen wie LED oder Laserlicht verwendet. So benötigt man ein Hologramm pro Komplementärfarbe (RGB), um Licht frequenzselektiv zu lenken und gleichzeitig vollfarbige Displays zu ermöglichen. Daher sind in bestimmten Displayaufbauten mehrer Hologramme ineinander in die Photopolymerschicht zu belichten.

Zudem können mittels der erfindungsgemäßen Schichtaufbauten auch holographische Bilder oder Darstellungen, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten hergestellt werden. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar. Auch ist es möglich derartige Hologramme zur Speicherung digitaler Daten zu verwenden, wobei verschiedenste Belichtungsverfahren (Shift-, Spatial- or Angular- Multiplexing) verwendet werden.

Ebenfalls Gegenstand der Erfindung ist eine optische Anzeige, umfassend einen erfindungsgemäßen Schichtaufbau .

Beispiele für derartige optische Anzeigen sind bildgebende Anzeigen auf Basis von Flüssigkristallen, organischen lichtemittierenden Dioden (OLED), LED-Displaytafeln, Microelektromechanische Systeme (MEMS) auf Basis von diffraktiver Lichtselektion, Electrowettingdisplays (E-ink) und Plasmabildschirmen. Derartige optische Anzeigen können autostereoskopische und/oder holographische Displays, transmittive und reflektive Projektionsleinwände oder Projektionsscheiben, Displays mit schaltbaren eingeschränkten Abstrahlverhalten für Privacyfilter und bidirektionalen Multiuserbildschirmen, virtuelle Bildschirme, Headup-Displays, Head-mounted Displays, Leuchtsymbole, Warnlampen, Signallampen, Scheinwerfer und Schautafeln sein.

Darüber hinaus ist auch die Verwendung eines erfindungsgemäßen Schichtaufbaus zur Herstellung von Sicherheitsdokumenten wie z.B. von Chipkarten, Ausweisdokumenten, 3D-Bildern, Produktschutzetiketten, Labeln, Banknoten oder holografisch optischen Elementen insbesondere für optische Anzeigen möglich.

Die Erfindung wird im Folgenden anhand von Beispielen näher erläutert.

## Erläuterung der Abbildungen

Abbildung 1: zeigt die Geometrie eines Holographie Media Testers (HMT) bei λ = 532 nm (DPSS Laser): M = Spiegel, S = Verschluss, SF = Raumfilter, CL = Kollimatorlinse, λ/2 = λ/2 Platte, PBS = polarisationsempfindlicher Strahlteiler, D = Detektor, I = Irisblende, α0 = -22.3°, β0 = 22.3° sind die Einfallswinkel der kohärenten Strahlen außerhalb der Probe (des Mediums) gemessen. RD = Referenzrichtung des Drehtisches.

Abbildung 2: Grafische Auswertung der Retardationsmessung von Substrat 2 mit Darstellung der Retardationsverteilung auf den Meßbereich von 199 mm x 149 mm

Abbildung 3: Grafische Auswertung der Retardationsmessung von Substrat 3 mit Darstellung der Retardationsverteilung auf den Meßbereich von 199 mm x 149 mm

Abbildung 4: Schematischer Aufbau einer verwendeten kontinuierlichen Film-Beschichtungsanlage (als Rolle-zu-Rolle-Verfahren)

Abbildung 5: Gemessene und nach Kogelnik angepaßt und gefitteten Braggkurve des erfindungsgemäßen Beispiels 1

**Messmethoden:**

**Isocyanatgehalt**

Die angegebenen NCO-Werte (Isocyanat-Gehalte) wurden gemäß DIN EN ISO 11909 bestimmt. Der vollständige Umsatz von NCO-Gruppen bzw. deren Abwesenheit in einem Reaktionsgemisch wurde IR-spektroskopisch nachgewiesen. So wurde dann ein vollständiger Umsatz angenommen, wenn im IR-Spektrum des Reaktionsgemisches keine NCO-Bande ($2261 cm^{-1}$) sichtbar war.

**Festkörpergehalt**

Von einem unlackierten Dosendeckel und einer Büroklammer wurde das Tara-Gewicht ermittelt. Dann wurden ca. lg der zu untersuchenden Probe nach der Einwaage in dem Dosendeckel mit der geeignet gebogenen Büroklammer gleichmäßig verteilt. Die Büroklammer verblieb zur Messung in der Probe. Die Einwaage wurde ermittelt, danach für 1 Stunde bei 125 °C in einen Laborofen erhitzt und anschließend die Auswaage bestimmt. Den Festkörpergehalt wurde gemäß folgender Gleichung bestimmt: Auswaage [g] * 100 / Einwaage [g] = Gew.-% Festkörper.

**Brechungsindexbestimmung**

Die Messung des Brechungsindex erfolgte bei Raumtemperatur für die festen Substrate bei einer Wellenlänge von 589,3 nm indem der Brechungsindex n in Abhängigkeit von der Wellenlänge der Probe aus den Transmissions- und Reflexionsspektren erhalten wird. Das Transmissions- und Reflexionsspektrum des Schichtaufbaus wurde mit einem Spektrometer der Firma STEAG ETA-Optik, CD-Measurement System ETA-RT gemessen und danach der spektrale Verlauf von n an die gemessenen Transmissions- und Reflexionsspektren angepasst. Dies geschah mit der internen Software des Spektrometers.

Die Messung des Brechungsindex der Photopolymere erfolgte nach Bleichen mit Licht gemäß DIN EN ISO 489 "Bestimmung des Brechungsindex von Kunststoffen" bei 589,3 nm mit einem Refraktometer Schmidt & Haensch DSR Lambda bei 23°C.

**Messung der holographischen Eigenschaften DE und $\Delta$n mittels Zweistrahlinterferenz in Transmissionsanordnung**

Die holographischen Eigenschaften wurden mittels einer Messanordnung gemäß Abbildung 1 wie folgt geprüft: Der Strahl eines DPSS Lasers (Emissionswellenlänge 532 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls wurden durch die Irisblenden (I) festgelegt. Der Durchmesser der Irisblendenöffnung betrug 0.4 cm. Die polarisationsabhängigen Strahlteiler (PBS) teilten den Laserstrahl in zwei kohärente gleich polarisierte Strahlen. Über die $\lambda/2$ Plättchen wurden die Leistung des Referenzstrahls auf 0.1 mW und die Leistung des Signalstrahls auf 0.1 mW eingestellt. Die Leistungen wurden mit den Halbleiterdetektoren (D) bei ausgebauter Probe bestimmt. Der Einfallswinkel ($\alpha_0$) des Referenzstrahls betrug-22.3°, der Einfallswinkel ($\beta_0$) des Signalstrahls beträgt 22.3°. Die Winkel wurden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die parallel zur Winkelhalbierenden der zwei auf die Probe einfallenden Strahlen lagen (Transmissionshologramm). Der Streifenabstand $\Lambda$, auch Gitterperiode genannt, im Medium betrug $\sim$ 700 nm (der Brechungsindex des Mediums zu -1.504 angenommen).

Abbildung 1 zeigt den holographischen Versuchsaufbau, mit dem die Beugungseffizienz (DE) gemessen wurde.

Es wurden auf folgende Weise Hologramme in die Photopolymerschicht geschrieben:

- Beide Shutter (S) sind für die Belichtungszeit *t* geöffnet.
- Danach wurde bei geschlossenen Shuttern (S) der Photopolymerschicht 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel (Ω) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. Ω wurde von der Probennormale zur Referenzrichtung des Drehtisches gemessen. Die Referenzrichtung (Ω = 0) des Drehtisches ergab sich dann, wenn beim Schreiben des Hologramms der Einfallswinkel des Referenz- und des Signalstrahls betragsmäßig gleich waren also $\alpha_0$ = -22.3° und $\beta_0$ = 22.3° galt. Allgemein galt für das Interferenzfeld beim Schreiben ("recording") eines symmetrischen Transmissionshologramms ($\alpha_0 = -\beta_0$):

$$\alpha_0 = \theta_0$$

$\theta_0$ war der Halbwinkel im Laborsystem außerhalb des Mediums. In diesem Fall galt also $\theta_0$ = -22.3°. An jedem angefahrenen Drehwinkel Ω wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel Ω als der Quotient aus:

$$\eta = \frac{P_D}{P_D + P_T}$$

$P_D$ war die Leistung im Detektor des abgebeugten Strahls und $P_T$ war die Leistung im Detektor des transmittierten Strahls.

Mittels des oben beschriebenen Verfahrens wurde die Braggkurve, sie beschreibt den Beugungswirkungsgrad η in Abhängigkeit des Drehwinkels Ω, des geschriebenen Hologramms gemessen und in einem Computer gespeichert. Zusätzlich wurde auch die in die nullte Ordnung transmittierte Intensität gegen den Drehwinkel Ω aufgezeichnet und in einem Computer gespeichert.

Die zentrale Beugungseffizienz (DE = $\eta_0$) des Hologramms, wurde bei Ω = 0 ermittelt.

Der Brechungsindexkontrast Δn und die Dicke d der Photopolymerschicht wurden nun mittels der Coupled Wave Theorie (siehe; H. Kogelnik, The Bell System Technical Journal, Volume 48, November 1969, Number 9 Seite 2909 - Seite 2947) an die gemessene Braggkurve angepasst. Das Auswerteverfahren wird im Folgenden beschrieben: Für die Braggkurve η(Ω) eines Transmissionshologramms gilt nach Kogelnik:

$$\eta = \frac{\sin^2\left(\sqrt{\nu^2 + \xi^2}\right)}{1 + \frac{\xi^2}{\nu^2}}$$

mit:

$$\nu = \frac{\pi \cdot \Delta n \cdot d}{\lambda \cdot \sqrt{|c_s \cdot c_r|}}$$

$$\xi = -\frac{d}{2 \cdot c_s} \cdot DP$$

$$c_s = \cos(\vartheta)$$

$$c_r = \cos(\vartheta)$$

$$DP = \frac{\pi}{\Lambda} \cdot \left( -2 \cdot \sin(\vartheta) - \frac{\lambda}{n \cdot \Lambda} \right)$$

$$\Lambda = -\frac{\lambda}{2 \cdot n \cdot \sin(\alpha)}$$

Beim Auslesen des Hologramms ("reconstruction") gilt wie analog oben dargestellt:

$$\vartheta_0 = \theta_0 + \Omega$$

$$\sin(\vartheta_0) = n \cdot \sin(\vartheta)$$

An der Bragg-Bedingung ist das "Dephasing" *DP* = 0. Und es folgt entsprechend:

$$\alpha_0 = \theta_0$$

$$\sin(\alpha_0) = n \cdot \sin(\alpha)$$

$\nu$ ist die Gitterstärke und $\xi$ ist der Detuning Parameter des Brechungsindexgitters das geschrieben wurde. n ist der mittlere Brechungsindex des Photopolymers und wurde zu 1.504 gesetzt. $\lambda$ ist die Wellenlänge des Laserlichts im Vakuum.

Die zentrale Beugungseffizienz (DE = $\eta_0$) ergibt sich dann für $\xi$ = 0 zu:

$$DE = \sin^2(\nu) = \sin^2\left( \frac{\pi \cdot \Delta n \cdot d}{\lambda \cdot \cos(\alpha)} \right)$$

Die Messdaten der Beugungseffizienz und die theoretische Braggkurve werden wie in Abbildung 5 gezeigt gegen den Drehwinkel $\Omega$ aufgetragen.

Da DE bekannt ist wird die Form der theoretischen Braggkurve nach Kogelnik nur noch durch die Dicke *d* der Photopolymerschicht bestimmt. $\Delta$n wird über DE für gegebene Dicke *d* so nachkorrigiert, dass Messung und Theorie von DE immer übereinstimmen. *d* wird nun solange angepasst bis die Winkelpositionen der ersten Nebenminima und die Höhen der ersten Nebenmaxima der theoretischen Braggkurve mit den Winkelpositionen der ersten Nebenminima und den Höhen der ersten Nebenmaxima der gemessenen Braggkurve übereinstimmen.

Abbildung 5 zeigt die Darstellung der Braggkurve $\eta$ nach der Coupled Wave Theorie (durchgezogene Linie) und des gemessenen Beugungswirkungsgrades (Kreise) gegen den Drehwinkel $\Omega$.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms $\Delta$n in den Sättigungswert übergeht. Die mittlere Energiedosis *E* ergibt sich wie folgt aus den Leistungen der zwei den Winkeln $\alpha_0$ und $\beta_0$ zugeordneten Teilstrahlen (Referenzstrahl mit $P_r$ = 0.01 mW und Signalstrahl mit $P_s$ = 0.01 mW), der Belichtungszeit t und dem Durchmesser der Irisblende (0.4 cm):

$$E\,(\mathrm{mJ/cm^2}) = \frac{2 \cdot [P_r + P_s] \cdot t\,(\mathrm{s})}{\pi \cdot 0.4^2\ \mathrm{cm}^2}$$

Für die Messung in Reflektionsanordnung sei hier auf WO2013053791A1, Seite 31 ff. verwiesen.

## Messung der Retardation

Die Substratschichten wurden mit einem Meßgerät der Fa. Ilis GmbH, D91052-Erlangen (Deutschland) Model Strainmatic M3 zur Bestimmung der optischen Retardation vermessen. Es handelt sich hierbei um ein bildgebendes Polarimetersystem, daß einen optischen Aufbau, bestehend aus Lichtquelle, Polarisator, Meßprobe, Lambda-Viertel-Platte, Analysator und Detektor besitzt. Als (Flächen)-Lichtquelle wurde monochromatisches Licht bei Lambda = 587 nm verwendet und wurde durch den Polarisator linear polarisiert. Durch den Probenkörper wurde das linear polarisierte Licht nun in elliptisch polarisiertes Licht gewandelt. Die Lambda-Viertel-Platte wandelte das Licht nun anschließend in linear polarisiertes Licht zurück, dessen Polarisationsebenen um einen bestimmten Winkel $\alpha$ zu der ursprünglichen Polarisationsrichtung von der Probe verdreht wurde. Mittels des Analysators und des ortsaufgelösten (CCD)-Detektors wurde dieser Winkel nun bestimmt. Die Retardation R wurde mittels der Beziehung

$$R = \frac{a \cdot \lambda}{180°}$$

in Nanometer [nm] errechnet. Bedingt durch das Meßprinzip wurde die Retardation nur bezüglich der Vorzugsrichtung des linear polarisierten Lichtes und Meßachsenanordnung bestimmt. Daher wurde der Polarisator anschließend in 90° Schritten gedreht und die Messung jeweils wiederholt. Mittels der Auswertesoftware (Version v2013.1.27.126) wurde diese geometrische Abhängigkeit zurückgerechnet und es wurde für die gemessene Bildgröße von 199,0 mm x 149,2 mm bei einem CCD-Detektorabstand von 465,0 mm eine Abbildung der optischen Retardation inklusive einer statistischen Auswertung erhalten.

## Bestimmung der optischen Güte

Das in einem Interferenzexperiment (z.B. einem Fizeau- oder auch Tyman-Green-Interferometer) sichtbar gemachte Phasenprofil zweier interferierender planarer Welle nach Durchgang durch einen Schichtaufbau wurde mittels CCD Kamera aufgezeichnet. Es ergaben sich über die gemessene Fläche eine der Pixelzahl der Kamera entsprechenden Zahl an Messpunkten, welche die Veränderung der Phase der Lichtwelle nach Durchgang durch den Schichtaufbau charakterisierten. Diese Änderungen konnten gegenüber einer Nullmessung ohne Probe, welches das Idealbild einer störungsfreien Anordnung darstellte statistisch auswertet werden. Gängige Kennzahlen sind der Peak-zu-Valley-Wert, der den maximalen Differenzabstand zwischen dem höchsten und niedrigsten Punkt angibt, sowie der RMS-Wert welcher definiert ist als die Wurzel des quadratischen Mittelwertes der Abweichung der gemessenen Phasenverteilung gegenüber der Idealverteilung. Beide Kennzahlen lassen sich für die Gesamtmenge an Messpunkten, sowie definierter Teilmengen ermitteln. Handelt es sich bei der Teilmenge um eine gerade Linie lässt sich die räumliche Ableitung des RMS bilden als Maß für die maximale Steigung und den Grad der Veränderlichkeit der Phase entlang einer Richtung. Diese Darstellung des RMS - also als Ableitung entlang einer Richtung - ist von besonderer Relevanz für holographisch optische Elemente.

Der Strehl-Wert S (das Strehlverhältnis) gibt eine Qualität der Abbildungsqualität eines optischen Systems an. Wie u.a. auch in DIN ISO 10110-5 definiert, beschreibt der Strehl-Wert ein Lichtintensitätsverhältnis der experimentell gemessenen Intensität eines Punktbildes im Verhältnis zu dem eines gleichen als störungsfrei angenommenen (also abberationsfreien) Abbildungssystems. Für einen interferometrischen Aufbau lässt sich leicht ein Strehlwert bestimmen, indem man über eine einfache Fouriertransformation das Bild einer gemessenen Phasenverteilung berechnet und ins Verhältnis zum Ideal einer ebenen Welle setzt. Die Phasenreichweitenlänge P stellt nun den Schlüsselparameter dar, der sich aus dem Quotienten von Strehl-Wert und der maximalen Steigung des RMS-Wert entlang zweier orthogonaler Richtungen ergibt. Er ist somit ein Parameter, der die Qualität der Abbildungsgüte (Strehl) mit der Abweichung von der Idealform einer planen Phasenfläche vereint. Eine Phasenreichweitenlänge P von mindestens 0,8 cm/Wellenlänge ist für einen erfindungsgemäßen Schichtaufbau gefordert, bevorzugt mindestens eine Phasenreichweitenlänge P von 1,0 cm/Wellenlänge, besonders bevorzugt von mindestens 1,2 cm/Wellenlänge. Als Messwellenlänge im Interferometer wurde 633 nm verwendet.

Die optische Güte des erhaltenen belichteten Schichtaufbaus wurde mittels eines Fizeau-Interferometers Model GPI-xpD der Fa. Zygo, Middlefield, CT (USA) bestimmt. Das Gerät besitzt eine Lasereinheit (Lambda = 633 nm) dessen Strahl aufgeweitet und kollimiert wurde auf die Größe zweier optisch planarer kreisförmiger Glasplatten (Flats) mit dem Durchmesser = 15 cm. Der aufgeweitete Laserstrahl durchleuchtete die beiden zueinander parallel ausgerichteten planen Glasplatten und die Rückinterferenz wurde durch eine CCD-Kamera (1024 x 1024 Pixel) aufgezeichnet. Dabei wurde zunächst eine Referenzmessung gegen eine mit Luft gefüllte Meßkavität (= der Bereich zwischen den Glasplatten) durchgeführt. Dieser sollte eine Phasenreichweitenlänge P > 10 ergeben. Die Phasenreichweitenlänge P errechnete sich dabei aus Q = Strehl/RMS (RMS=Quadratische Mittel der Varianz von $n \cdot d$, mit n= Brechungsindex des Materials

und d=Schichtdicke). Falls dies nicht erreicht wurde, justierte man die Ausrichtung der Glasplatten zueinander so, sodaß diese parallel zueinander waren. Eine entsprechende Prüfung erfolgte durch visuelle Beobachtung mit der CCD-Kamera am Kontrollmonitor, bis keine Interferenzstreifen mehr im Meßbereich sichtbar waren.

Die zu vermessende Folienprobe wurde auf einen Metallrahmen der Größe 10 cm x 10 cm aufgeklebt und zwischen die Glasplatten frei positioniert. Das Meßfenster wurde in Form einer Messmaske per Software (Metropro V8.3.5, Fa. Zygo) angelegt. Die Messung wurde gestartet und per Software automatisch CCD-Kameraabbilder aufgezeichnet. Die Messung dauert automatisch gesteuert 1-15 Sekunden, je nach Planarität des Meßgutes. Folgende Einstellungsparameter wurden gewählt: Auflösung +/- 1 Wellenlänge, Distanz der Auswertung erfolgte über 10 cm, Höhenausschläge werden auf die maximale Ausdehnung kalibriert. Aus dem erhaltenen räumlich aufgelösten Meßbild errechnete die Software die Phasenreichweitenlänge P, Strehl und RMS.

**Chemikalien und Substrate:**

**Herstellung von Polyol 1:**

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Herstellung des Urethanacrylats 1 (Schreibmonomer): Phosphorothioyltris(oxybenzol-4,1-diylcarbamoyloxyethan-2,1-diyl)trisacrylat**

In einem 500 mL Rundkolben wurden 0.1 g 2,6-Di-tert.-butyl-4-methylphenol, 0.05 g Dibutylzinndilaurat sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und das Ethylacetat im Vakuum vollständig entfernt. Das Produkt wurde als teilkristalliner Feststoff erhalten.

**Herstellung des Urethanacrylats 2 (Schreibmonomer): 2-({[3-(Methylsulfanyl)phenyl]-carbamoyl}oxy)ethylprop-2-enoat**

In einem 100 mL Rundkolben wurden 0.02 g 2,6-Di-tert.-butyl-4-methylphenol, 0.01 g Desmorapid Z, 11.7 g 3-(Methylthio)phenylisocyanat [28479-1-8] vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als farblose Flüssigkeit erhalten.

**Herstellung des Additivs 1 Bis(2,2,3,3,4,4,5,5,6,6,7,7-dodecafluorheptyl)-(2,2,4-trimethylhexan-1,6-diyl)biscarbamat**

In einem 50 mL Rundkolben wurden 0.02 g Desmorapid Z und 3.6 g 2,4,4-Trimethylhexane-1,6-diisocyanat (TMDI) vorgelegt und auf 60 °C erwärmt. Anschließend wurden 11.9 g 2,2,3,3,4,4,5,5,6,6,7,7-Dodecafluorheptan-1-ol zugetropft und die Mischung weiter auf 60 °C gehalten, bis der Isocyanatgehalt unter 0.1 % gesunken war. Danach wurde abgekühlt. Das Produkt wurde als farbloses Öl erhalten.

**Borat (Photoinitiator):**

Die Herstellung des Borats erfolgte nach Beispiel 1 der europäischen Anmeldung EP 13189138.4. Es wurde eine 51,9%ige Lösung des Benzyl-dimethylhexadecylammoniumborats erhalten.

**Farbstoff 1:**

Die Herstellung des Farbstoffs ist in Beispiel 1 der WO 2012 062655 beschrieben.

**Farbstoff 2:**

Die Herstellung des Farbstoffs ist in Beispiel 9 aus der WO 2012 062655 beschrieben.

**Farbstoff 3:**

Die Herstellung des Farbstoffs ist in Beispiel 15 aus der WO 2012 062655 beschrieben.

**Farbstoff 4:**

Die Herstellung des Farbstoffs ist in Beispiel 14 aus der WO 2012 062655 beschrieben.

**Substrat 1:**

Transphan OG622 GL eine 60 μm dicke Polyamidfolie der LOFO high Tech Film GMBH, DE-79576 Weil am Rhein (Deutschland), der Brechungsindex nD wurde bestimmt zu 1,547.

**Substrat 2:**

Tacphan 915-GL eine 50 μm dicke Triacetatfolie der LOFO high Tech Film GMBH, DE-79576 Weil am Rhein (Deutschland), der Brechungsindex nD wurde bestimmt zu 1,475.

**Substrat 3:**

Makrofol DE 1-1 eine 125 μm dicke Polycarbonatfolie der Bayer MaterialScience AG, DE-51368 Leverkusen (Deutschland), der Brechungsindex nD wurde bestimmt zu 1,596.

**Substrat 4:**

Hostaphan RNK 36, eine 36 μm dicke Polyethylenterephtalatfolie der Mitsubishi Polyester Film GmbH, D-65203 Wiesbaden (Deutschland), der Brechungsindex nD wurde bestimmt zu 1,668.

**Substrat 5:**

Pokalon Pokalon OG 641 GL, eine 75 μm dicke Polycarbonatfolie der LOFO high Tech Film GMBH, DE-79576 Weil am Rhein (Deutschland), der Brechungsindex nD wurde bestimmt zu 1,576.

**Substrat 6:**

Pokalon OG 642 GL, eine 80 μm dicke Polycarbonatfolie der LOFO high Tech Film GMBH, DE-79576 Weil am Rhein (Deutschland), der Brechungsindex nD wurde bestimmt zu 1,576.

**Substrat 7:**

Tacphan I 800 GL, eine 40 μm dicke Triacetatfolie der LOFO high Tech Film GMBH, DE-79576 Weil am Rhein (Deutschland), der Brechungsindex nD wurde bestimmt zu 1,485.

| | |
|---|---|
| Desmodur® N 3900 | Produkt der Bayer MaterialScience AG, Leverkusen, DE, Hexandiisocyanatbasiertes Polyisocyanat, Anteil an Iminooxadiazindion mindestens 30 %, NCO-Gehalt: 23.5 %. |
| Trimethylhexamethylendiisocyanat | [28679-16-5] - ABCR GmbH & Co KG, Karlsruhe, Deutschland |
| 1H,1H-7H-Perfluorheptan-1-ol | [335-99-9] - ABCR GmbH & Co KG, Karlsruhe, Deutschland |
| Desmorapid Z | Dibutylzinn-dilaurat [77-58-7], Produkt der Bayer MaterialScience AG, Leverkusen, Deutschland. |
| Fomrez UL 28 | Urethanisierungskatalysator, Handelsprodukt der Momentive Performance Chemicals, Wilton, CT, USA. |
| Natrium-bis(2-ethylhexyl)-sulfosuccinat | [45297-26-5] ist bei Aldrich Chemie, Steinheim erhältlich. |
| 4-Chlorphenylmagnesiumbromid | [873-77-8] ist als 0.9 M Lösung in THF/Toluol bei Aldrich Chemie, Steinheim erhältlich. |
| Tetrabutylammoniumbromid | [1643-19-2] ist bei ABCR GmbH & CO. KG, Karlsruhe erhältlich. |

(fortgesetzt)

| | |
|---|---|
| BYK® 310 | silikonbasiertes Oberflächenadditiv der Firma BYK-Chemie GmbH, Wesel, 25%ige Lösung in Xylol |
| Ethylacetat | [141-78-6] Lösungsmittel |

**Bestimmung der Retardation der Substrate**

Tabelle 1 zeigt die Ergebnisse der Retardationsmessung der Substrate 1-7. Die Substrate 1 und 2 zeigen niedrige Retardationswerte und sind für erfindungsgemäße Schichtaufbauten geeignet. Die Substrate 3 und 4 weisen dagegen zu hohe Retardationswerte auf und werden daher nicht für erfindungsgemäße Schichtaufbauten verwendet.

Tabelle 1: Maximale und durchschnittliche Retardation der Substrate 1-7 sowie deren Standardabweichung in [nm]; siehe auch Abbildung 2, die die grafische Auswertung des Substrats 2 und Abbildung 3, die die grafische Auswertung des Substrats 3 zeigen.

| | Maximale Retardation | Durchschnittliche Retardation | Standardabweichung |
|---|---|---|---|
| Substrat 1 | 30,4 nm | 20,0 nm | 3,5 nm |
| Substrat 2 | 2,3 nm | 1,1 nm | 0,3 nm |
| Substrat 3 | 220,4 nm | 94,8 nm | 44,8 nm |
| Substrat 4 | 2762,0 nm | 740,6 nm | 101,4 nm |
| Substrat 5 | 12,7 nm | 7,7 nm | 1,6 nm |
| Substrat 6 | 12,2 nm | 7,8 nm | 1,0 nm |
| Substrat 7 | 2,8 nm | 0,5 um | 0,2 nm |

**Herstellung von Schichtaufbauten auf einer Folienbeschichtungsanlage**

Im Folgenden wird die kontinuierliche Herstellung von Schichtaufbauten beschrieben.

Abbildung 4 zeigt den schematischen Aufbau der verwendeten Beschichtungsanlage. In der Abbildung haben die einzelnen Bauteile die folgenden Bezugszeichen:

1 Vorratsbehälter

2 Dosiereinrichtung

3 Vakuumentgasungseinrichtung

4 Filter

5 Statischer Mischer

6 Beschichtungseinrichtung

7 Umlufttrockner

8 Substratschicht

9 Abdeckschicht

Zur Herstellung der Photopolymer-Formulierung 1 wurden 38,6 Teile des Polyols 1, je 18,1 Teile des Urethanacrylat 1 und Urethanacrylat 2, 25 Teile des Additivs 1, 1 Teil des BYK 310, 0,22 Teile Farbstoff 1 als eine Ethylacetatlösung (Mengengehalt siehe Tabelle 2) hergestellt .. Dieses Gemisch wurde in einen der beiden Vorratsbehälter 1 der Beschichtungsanlage eingebracht. In den zweiten Vorratsbehälter 1 wurden 7,32 Teile Desmodur N3900 und 3,22 Teile Boratgefüllt. Als Stabilisatoren wurde ein Gemisch aus sterisch gehindertes Amin und einem Phenol eingesetzt, als

Urethanisierungskatalysator wurden 0,075 Teile Fomrez UL 28 verwendet. Photopolymer 2 unterscheidet sich von Photopolymer 1 in seiner Menge an Urethanacrylat 1 (7.5% auf Festharz), Urethanacrylat 2 (7.5% auf Festharz), Additiv 1 (10% auf Festharz) sowie statt Farbstoff 1 wurde eine Mischung aus Farbstoff 2, 3 und 4 verwendet

Beide Komponenten wurden dann jeweils durch die Dosiereinrichtungen 2 zur Vakuumentgasungseinrichtung 3 gefördert und entgast. Von hier aus wurden sie dann jeweils durch die Filter 4 in den statischen Mischer 5 geleitet, in dem die Vermischung der Komponenten erfolgte. Die erhaltene, flüssige Masse wurde dann im Dunklen der Beschichtungseinrichtung 6 zugeführt.

Bei der Beschichtungseinrichtung 6 handelte es sich im vorliegenden Fall um eine dem Fachmann bekannte Schlitzdüse. Mit Hilfe der Beschichtungseinrichtung 6 wurde die Photopolymer-Formulierung bei einer Verarbeitungstemperatur von 20 °C auf die jeweilige Substratschicht (siehe auch Tabelle 3 und 4) appliziert und im Umlufttrockner 7 getrocknet. Dabei wurde ein Schichtaufbau in der Form eines beschichteten Films erhalten, der dann mit einer 40 μm Polyethylenfolie als Abdeckschicht 9 versehen und aufgewickelt wurde. Tabelle 2 zeigt die individuellen Beschichtungsbedingungen.

Tabelle 2: Herstellparameter

| Beispiel | Lösemittelgehalt (Gew.-%) | Dicke Photopolymerschicht (μm) | Trocknertemperatur (°C) | Verweilzeit im Trockner (min) |
|---|---|---|---|---|
| 1 | 50 | 16 | 100 | 3,3 |
| 2 | 50 | 16 | 100 | 4,3 |
| 3 | 50 | 16 | 100 | 3,3 |
| 4 | 60 | 10 | 100 | 3,3 |
| 5 | 60 | 10 | 100 | 3,3 |

Für Photopolymer 1 wurde ein Brechungsindex nD= 1,491 und für Photopolymer 2 ein Brechungsindex nD=1,505 bestimmt.

Tabelle 3 beschreibt drei verschiedene Schichtaufbauten, die auf Photopolymer 1 basieren, sich aber durch drei verschiedene Substrate 2, 3 und 4 unterscheiden. Alle drei Schichtaufbauten zeigen gute holographische Eigenschaften (in Form der Indexmodulation Δn). Die durchschnittliche Retardation der Substrate 3 und 4 ist deutlich über 60 nm, deren Phasenreichweitenlänge P unterhalb der geforderten 0,8 cm/Wellenlänge (Wv = Wellenlänge). Die Schichtaufbauten aus Beispiel 2 und 3 sind daher nicht erfindungsgemäß. Nur der erfindungsgemäße Schichtaufbau aus Beispiel 1 mit dem Substrat 2 mit einer durchschnittliche Retardation < 60 nm zeigt eine gute Phasenreichweitenlänge P von 1,20 cm/ Wellenlänge.

Tabelle 3: Schichtaufbaueigenschaften und optische Eigenschaften

| | erfindungsgemäßes Beispiel 1 | nicht erfindungsgemäßes Beispiel 2 | nicht erfindungsgemäßes Beispiel 3 |
|---|---|---|---|
| Substrat | Substrat 2 | Substrat 3 | Substrat 4 |
| Brechungsindex des Substrats | 1,475 | 1,596 | 1,668 |
| Photopolymer | 1 | 1 | 1 |
| Brechungsindex des Photopolymers | 1,491 | 1,491 | 1,491 |
| Betrag der Differenz des Brechungsindexes | 0,016 | 0,105 | 0,177 |
| Durchschnittliche Retardation der Substratschicht | 1,1 nm | 94,8 nm | 740,6 nm |
| Schichtaufbaueigenschaften | | | |
| Strehl | 0,69 | 0,63 | 0,47 |
| RMS-Wert | 0,59 Wv/cm | 0,99 Wv/cm | 1,25Wv/cm |

(fortgesetzt)

| Schichtaufbaueigenschaften | | | |
|---|---|---|---|
| Phasenreichweitenlänge P | 1,20 cm/Wv | 0,64 cm/Wv | 0,37cm/Wv |
| Holographische Performance $\Delta n$ | 0,034 @ 16mJ/cm2 (532nm, transmission) | 0,031 @ 16mJ/cm2 (532nm, reflektion) | 0,031 @ 16mJ/cm2 (532nm, reflektion) |

Tabelle 4 zeigt zwei erfindungsgemäße Beispiele mit hinreichend niedriger durchschnittliche Retardation und folglich sehr guter Phasenreichweitenlänge P > 1,20 cm/Wellenlänge. Alle erfindungsgemäßen Beispiele zeigen zudem gute holographische Eigenschaften. [Wv = Wellenlänge]

Tabelle 4: Schichtaufbaueigenschaften und optische Eigenschaften

| | erfindungsgemäßes Beispiel 4 | erfindungsgemäßes Beispiel 5 |
|---|---|---|
| Substrat | Substrat 1 | Substrat 2 |
| Brechungsindex des Substrats | 1,547 | 1,475 |
| Photopolymer | 2 | 2 |
| Brechungsindex des Photopolymers | 1,505 | 1.505 |
| Betrag der Differenz des Brechungsindexes | 0,042 | 0,030 |
| Durchschnittliche Retardation | 20,4 nm | 1,1 nm |
| Schichtaufbaueigenschaften | | |
| Strehl | 0,79 | 0,87 |
| RMS-Wert | 0,55 Wv/cm | 0,40 Wv/cm |
| Phasenreichweitenlänge P | 1,44 cm/Wv | 2,19 cm/Wv |
| Holographische Performance $\Delta n$ | 0,013@16mJ/cm2 (532nm, transmission) | 0,011@16mJ/cm2 (532nm, transmission) |

## Patentansprüche

1. Schichtaufbau umfassend eine Substratschicht und eine zumindest abschnittsweise mit der Substratschicht verbundene Photopolymerschicht, **dadurch gekennzeichnet, dass** die Substratschicht eine durchschnittliche Retardation von ≤ 60 nm aufweist, wobei die Photopolymerschicht Matrixpolymere, Schreibmonomere und ein Photoinitiatorsystem umfasst.

2. Schichtaufbau nach Anspruch 1, **dadurch gekennzeichnet, dass** die Substratschicht eine durchschnittliche Retardation von ≤ 40 nm und bevorzugt von ≤ 30 nm aufweist.

3. Schichtaufbau nach einem der vorhergehenden Ansprüche, **dadurch gekennzeichnet, dass** die durchschnittliche Retardation der Substratschicht bestimmt wird, indem mit einem bildgebenden Polarimetersystem, umfassend eine monochromatische LED-Lichtquelle, einen Polarisator, eine Meßprobe, eine Lambda-Viertel-Platte, einen Analysator und einen Detektor die Polarisationsebenendrehung $\alpha$ ortsaufgelöst gemessen und mittels der Messfrequenz $\lambda$ und der Formel $R = \alpha * \lambda /180°$ die bestimmte ortaufgelöste Retardation R berechnet und anschließend über alle ortsaufgelöste Retardationswerte arithmetisch gemittelt wird, wobei die LED-Lichtquelle ein schmalbandiges Emissionsspektrum mit einer Halbwertbreite < 50 nm sowie eine maximale Emissionswellenlänge von $\lambda$ = 580 nm bis 595 nm aufweist.

4. Schichtaufbau nach einem der vorhergehenden Ansprüche, **dadurch gekennzeichnet, dass** die Substratschicht eine maximale (ortsaufgelöste) Retardation von ≤ 200 nm, bevorzugt von ≤ 100 nm und besonders bevorzugt von ≤ 50 nm aufweist.

5. Schichtaufbau nach Anspruch 1, **dadurch gekennzeichnet, dass** die Matrixpolymere Polyurethane umfassen oder daraus bestehen und bevorzugt dreidimensional vernetzte Polyurethane umfassen oder daraus bestehen.

6. Schichtaufbau nach einem der Ansprüche 1 oder 5, **dadurch gekennzeichnet, dass** die Schreibmonomere ein oder mehrere Urethan-(meth)-acrylate umfassen oder daraus bestehen.

7. Schichtaufbau nach einem der Ansprüche 1, 5 oder 6, **dadurch gekennzeichnet, dass** das Photoinitiatorsystem aus einem im sichtbaren spektralen Bereich absorbierenden Sensibilisator und einem Coinitiator besteht.

8. Schichtaufbau nach einem der Ansprüche 1, 5, 6 oder 7, **dadurch gekennzeichnet, dass** die Photopolymerschicht Fluorurethane umfasst, wobei diese bevorzugt Verbindungen gemäß der Formel (II) sein können

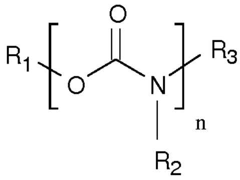

(II)

in der n≥1 und n≤8 ist und $R_1$, $R_2$, $R_3$ unabhängig voneinander Wasserstoff, lineare, verzweigte, cyclische oder heterocyclische unsubstituierte oder gegebenenfalls auch mit Heteroatomen substituierte organische Reste sind, wobei mindestens einer der Reste $R_1$, $R_2$, $R_3$ mit wenigstens einem Fluoratom substituiert ist und besonders bevorzugt $R_1$ ein organischer Rest mit mindestens einem Fluoratom ist.

9. Schichtaufbau nach einem der vorhergehenden Ansprüche, **dadurch gekennzeichnet, dass** die Substratschicht in dem Wellenlängenbereich von 410 bis 780 nm eine Mindesttransmission ≥ 70%, bevorzugt von ≥ 75% und besonders bevorzugt von ≥ 80% aufweist.

10. Schichtaufbau nach einem der vorhergehenden Ansprüche, **dadurch gekennzeichnet, dass** die Substratschicht eine essentiell elastische Dehnung von maximal 0,2% bei einer Substratbreite von einem Meter bei einer Zugkraft von mindestens 80 Newton, bevorzugt von mindestens 110 Newton und besonders bevorzugt von mindestens 140 Newton aufweist.

11. Schichtaufbau nach einem der vorhergehenden Ansprüche, **dadurch gekennzeichnet, dass** der Betrag der Differenz des Brechungsindexes bei 589,3 nm der Substratschicht und der Photopolymerschicht ≤ 0,075, bevorzugt ≤ 0,065 und besonders bevorzugt ≤ 0,050 ist, wobei der Brechungsindex des Photopolymers gemäß DIN EN ISO 489 und für die Substrate durch Anpassung des spektralen Brechungsindexverlaufs aus den visuellen Reflektions- und Transmissionspektren bestimmt wird.

12. Schichtaufbau nach einem der vorhergehenden Ansprüche, **dadurch gekennzeichnet, dass** die Substratschicht und die Photopolymerschicht vollflächig miteinander verbunden sind.

13. Schichtaufbau nach einem der vorhergehenden Ansprüche, **dadurch gekennzeichnet, dass** die Substratschicht eine Dicke von 10 bis 250 µm, bevorzugt von 20 bis 180 µm und besonders bevorzugt von 35 bis 150 µm und / oder die Photopolymerschicht eine Dicke von 0,3 bis 200 µm und bevorzugt von 1 bis 100 µm aufweist.

14. Schichtaufbau nach einem der vorhergehenden Ansprüche, **dadurch gekennzeichnet, dass** in die Photopolymerschicht wenigstens ein Hologramm einbelichtet ist.

15. Optische Anzeige, umfassend einen Schichtaufbau gemäß einem der vorhergehenden Ansprüche.

## Claims

1. Layered setup comprising a substrate layer and a photopolymer layer bonded thereto at least segmentally, **characterized in that** the substrate layer has an average retardation of ≤ 60 nm, wherein the photopolymer layer comprises matrix polymers, writing monomers and a photoinitiator system.

2. Layered setup according to Claim 1, **characterized in that** the substrate layer has an average retardation of ≤ 40 nm and preferably of ≤ 30 nm.

3. Layered setup according to either preceding claim, **characterized in that** the average retardation of the substrate layer is quantified by an imaging polarimeter system comprising a monochromatic LED light source, a polarizer, a sample, a lambda quarter plate, an analyser and a detector, being used to measure the polarization plane rotation $\alpha$ in a positionally resolved manner and the quantified positionally resolved retardation R being computed by the formula $R = \alpha^*\lambda/180°$, where $\lambda$ is the measuring frequency, and then being arithmetically averaged over all positionally resolved retardation values, wherein the LED light source has a narrow-banded emission spectrum having a full width at half maximum value < 50 nm and also a maximum emission wavelength of $\lambda$ = 580 nm to 595 nm.

4. Layered setup according to any preceding claim, **characterized in that** the substrate layer has a maximum (positionally resolved) retardation of ≤ 200 nm, preferably of ≤ 100 nm and more preferably of ≤ 50 nm.

5. Layered setup according to Claim 1, **characterized in that** the matrix polymers comprise or consist of polyurethanes and preferably comprise or consist of three-dimensionally crosslinked polyurethanes.

6. Layered setup according to either of Claims 1 and 5, **characterized in that** the writing monomers comprise or consist of one or more urethane (meth)acrylates.

7. Layered setup according to any of Claims 1, 5 and 6, **characterized in that** the photoinitiator system consists of a sensitizer that absorbs in the visible spectrum and of a co-initiator.

8. Layered setup according to any of Claims 1, 5, 6 and 7, **characterized in that** the photopolymer layer comprises fluorourethanes, wherein these may preferably be compounds conforming to formula (II)

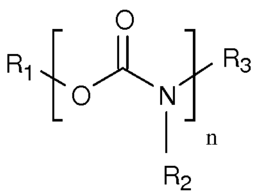

(II)

where n is ≥ 1 and ≤ 8 and $R_1$, $R_2$ and $R_3$ are each independently hydrogen or linear, branched, cyclic or heterocyclic unsubstituted or else optionally heteroatom-substituted organic moieties, wherein at least one of $R_1$, $R_2$ and $R_3$ is substituted with at least one fluorine atom and more preferably $R_1$ is an organic moiety having at least one fluorine atom.

9. Layered setup according to any preceding claim, **characterized in that** the substrate layer has a minimum transmission ≥ 70%, preferably ≥ 75% and more preferably ≥ 80% in the wavelength range from 410 to 780 nm.

10. Layered setup according to any preceding claim, **characterized in that** the substrate layer has an essentially elastic strain of not more than 0.2% at a substrate width of one metre in response to a tensile force of at least 80 newtons, preferably of at least 110 newtons and more preferably of at least 140 newtons.

11. Layered setup according to any preceding claim, **characterized in that** the magnitude of the difference in refractive index at 589.3 nm between the substrate layer and the photopolymer layer is ≤ 0.075, preferably ≤ 0.065 and more preferably ≤ 0.050, wherein refractive index is determined for the photopolymer as per DIN EN ISO 489 and for the substrates by fitting the spectral course of refractive index on the basis of the visual reflection and transmission spectra.

12. Layered setup according to any preceding claim, **characterized in that** the substrate layer and the photopolymer layer are bonded to each other uniformly.

13. Layered setup according to any preceding claim, **characterized in that** the substrate layer is from 10 to 250 µm, preferably from 20 to 180 µm and more preferably from 35 to 150 µm in thickness and/or the photopolymer layer

is from 0.3 to 200 μm and preferably from 1 to 100 μm in thickness.

**14.** Layered setup according to any preceding claim, **characterized in that** the photopolymer layer contains at least one exposed hologram.

**15.** Optical display comprising a layered setup according to any preceding claim.

**Revendications**

**1.** Structure en couches comprenant une couche de substrat et une couche de photopolymère reliée au moins en sections avec la couche de substrat, **caractérisée en ce que** la couche de substrat présente un retard moyen ≤ 60 nm, la couche de photopolymère comprenant des polymères de matrice, des monomères d'écriture et un système de photoinitiateur.

**2.** Structure en couches selon la revendication 1, **caractérisée en ce que** la couche de substrat présente un retard moyen ≤ 40 nm et de préférence ≤ 30 nm.

**3.** Structure en couches selon l'une quelconque des revendications précédentes, **caractérisée en ce que** le retard moyen de la couche de substrat est déterminé par mesure à résolution spatiale de la rotation du plan de polarisation $\alpha$ avec un système de polarimètre d'imagerie, comprenant une source de lumière LED monochromatique, un polariseur, une sonde de mesure, une lame quart d'onde, un analyseur et un détecteur, et calcul du retard à résolution spatiale R déterminé au moyen de la fréquence de mesure $\lambda$ et de la formule $R = \alpha^*\lambda/180°$, puis moyenne arithmétique de toutes les valeurs de retard à résolution spatiale, la source de lumière LED présentant un spectre d'émission à bande étroite ayant une largeur à mi-hauteur < 50 nm et une longueur d'onde d'émission maximale $\lambda$ = 580 nm à 595 nm.

**4.** Structure en couches selon l'une quelconque des revendications précédentes, **caractérisée en ce que** la couche de substrat présente un retard maximal (à résolution spatiale) ≤ 200 nm, de préférence ≤ 100 nm et de manière particulièrement préférée ≤ 50 nm.

**5.** Structure en couches selon la revendication 1, **caractérisée en ce que** les polymères de matrice comprennent des polyuréthanes ou en sont constitués, et comprennent de préférence des polyuréthanes réticulés tridimensionnellement ou en sont constitués.

**6.** Structure en couches selon l'une quelconque des revendications 1 ou 5, **caractérisée en ce que** les monomères d'écriture comprennent un ou plusieurs (méth)acrylates d'uréthane ou en sont constitués.

**7.** Structure en couches selon l'une quelconque des revendications 1, 5 ou 6, **caractérisée en ce que** le système de photoinitiateur est constitué par un sensibilisateur absorbant dans la plage spectrale visible et un co-initiateur.

**8.** Structure en couches selon l'une quelconque des revendications 1, 5, 6 ou 7, **caractérisée en ce que** la couche de photopolymère comprend des fluorouréthanes, ceux-ci pouvant de préférence être des composés selon la formule (II) :

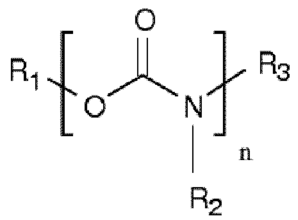

(II)

dans laquelle n ≥ 1 et n ≤ 8, et $R_1$, $R_2$, $R_3$ sont indépendamment les uns des autres l'hydrogène, des radicaux organiques linéaires, ramifiés, cycliques ou hétérocycliques non substitués ou éventuellement également substitués avec des hétéroatomes, au moins un des radicaux $R_1$, $R_2$, $R_3$ étant substitué avec au moins un atome de fluor, et

$R_1$ étant de manière particulièrement préférée un radical organique comprenant au moins un atome de fluor.

**9.** Structure en couches selon l'une quelconque des revendications précédentes, **caractérisée en ce que** la couche de substrat présente dans la plage de longueurs d'onde allant de 410 à 780 nm une transmission minimale ≥ 70 %, de préférence ≥ 75 % et de manière particulièrement préférée ≥ 80 %.

**10.** Structure en couches selon l'une quelconque des revendications précédentes, **caractérisée en ce que** la couche de substrat présente un allongement essentiellement élastique d'au plus 0,2 % à une largeur de substrat d'un mètre à une force de traction d'au moins 80 Newton, de préférence d'au moins 110 Newton, et de manière particulièrement préférée d'au moins 140 Newton.

**11.** Structure en couches selon l'une quelconque des revendications précédentes, **caractérisée en ce que** le montant de la différence entre les indices de réfraction à 589,3 nm de la couche de substrat et de la couche de photopolymère est ≤ 0,075, de préférence ≤ 0,065 et de manière particulièrement préférée ≤ 0,050, l'indice de réfraction du photopolymère étant déterminé selon DIN EN ISO 489 et, pour les substrats, par adaptation de la progression spectrale de l'indice de réfraction à partir des spectres de réflexion et de transmission visuels.

**12.** Structure en couches selon l'une quelconque des revendications précédentes, **caractérisée en ce que** la couche de substrat et la couche de photopolymère sont reliées l'une avec l'autre sur l'ensemble de la surface.

**13.** Structure en couches selon l'une quelconque des revendications précédentes, **caractérisée en ce que** la couche de substrat présente une épaisseur de 10 à 250 μm, de préférence de 20 à 180 μm, et de manière particulièrement préférée de 35 à 150 μm, et/ou la couche de photopolymère présente une épaisseur de 0,3 à 200 μm, et de préférence de 1 à 100 μm.

**14.** Structure en couches selon l'une quelconque des revendications précédentes, **caractérisée en ce qu'**au moins un hologramme est exposé dans la couche de photopolymère.

**15.** Affichage optique, comprenant une structure en couches selon l'une quelconque des revendications précédentes.

Abbildung 1:

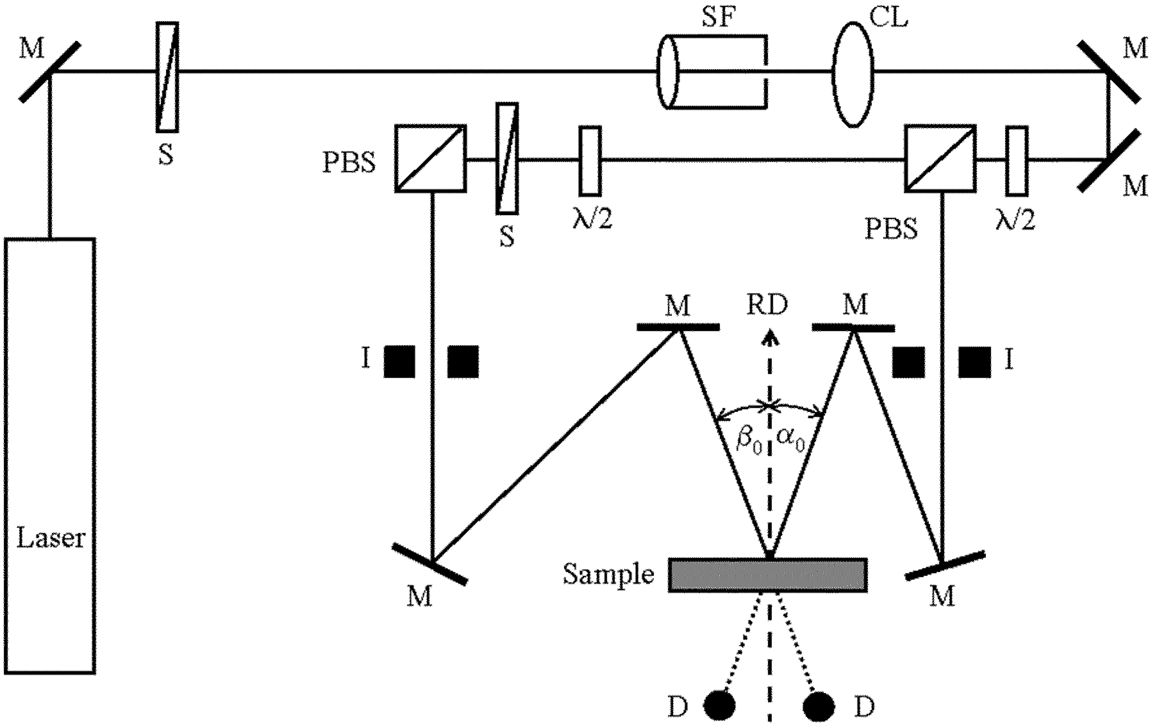
M
S
SF
CL
M
PBS
S
λ/2
PBS
λ/2
M
M
RD
M
I
I
$\beta_0$
$\alpha_0$
Laser
Sample
M
M
D
D

Abbildung 2:

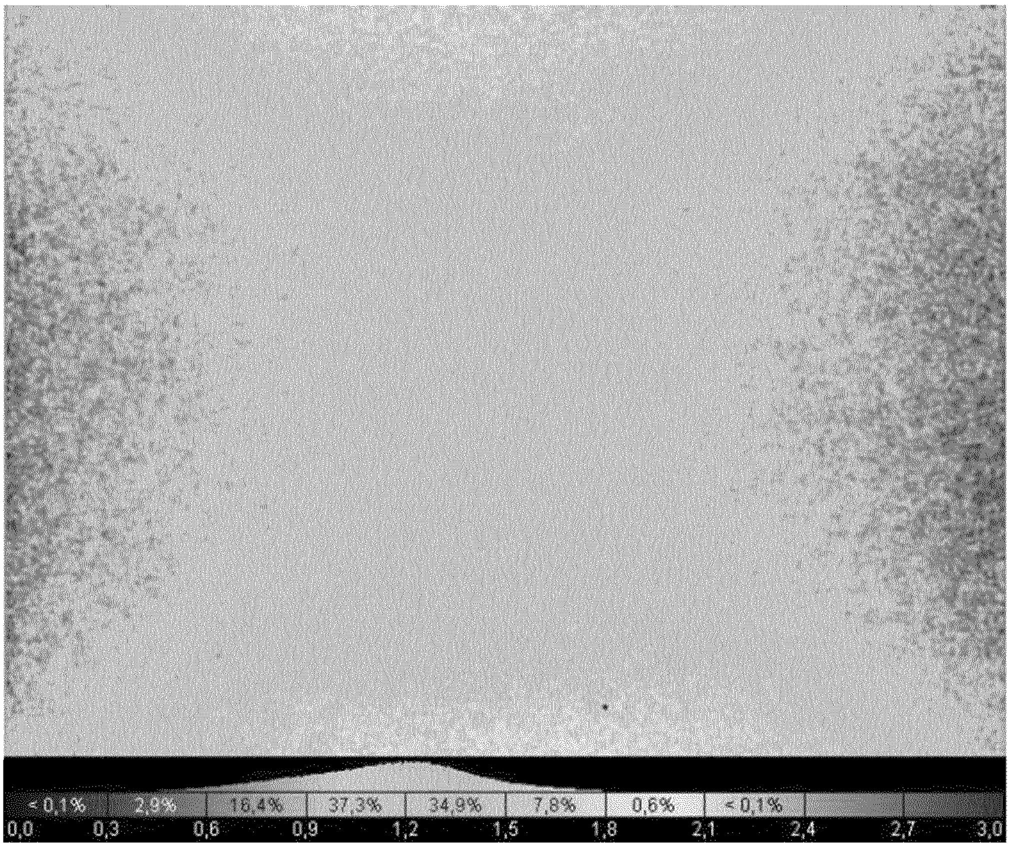

Abbildung 3:

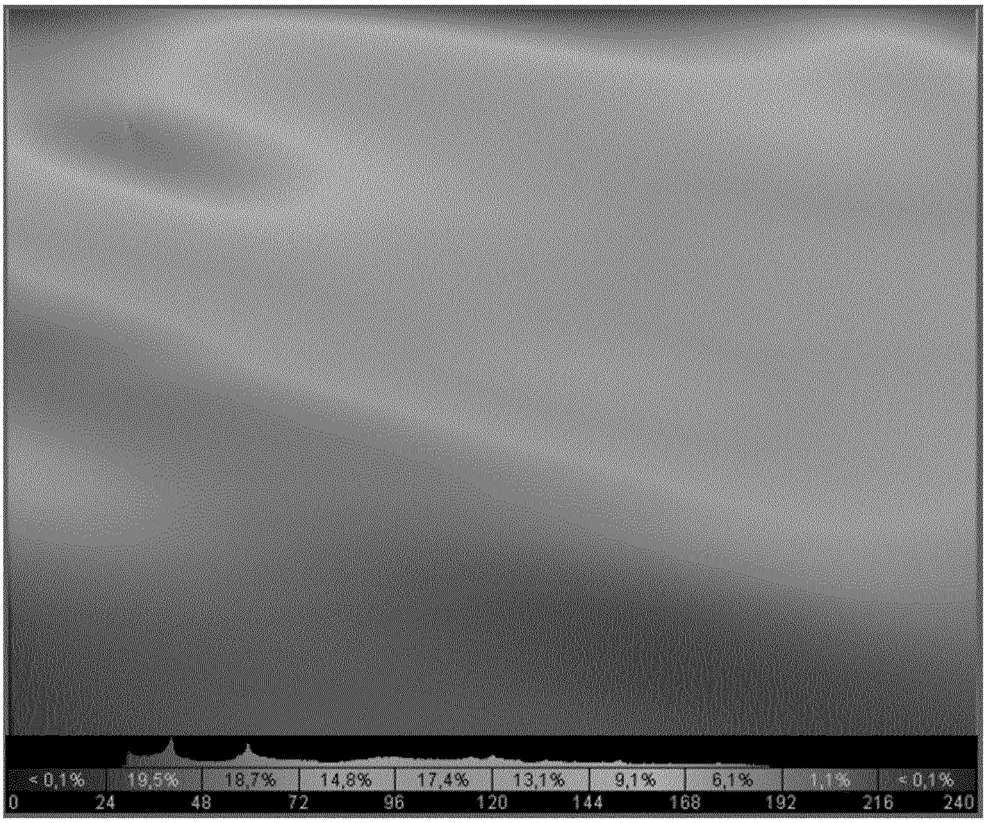


Abbildung 4:

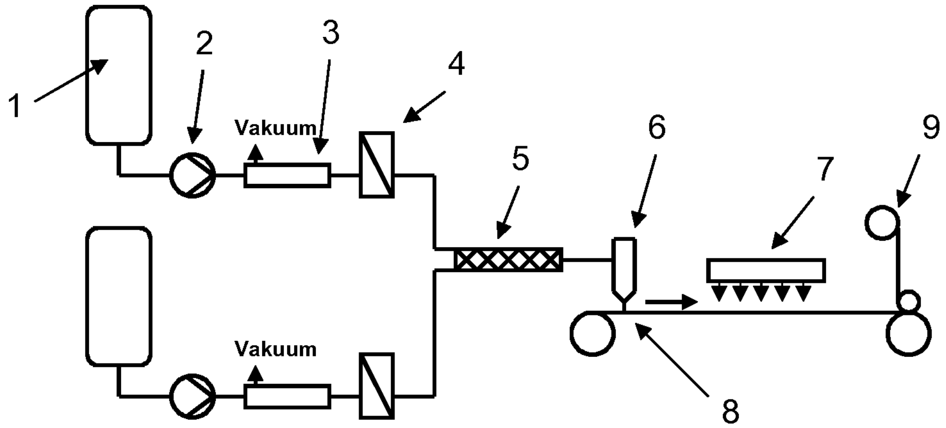

Abbildung 5:

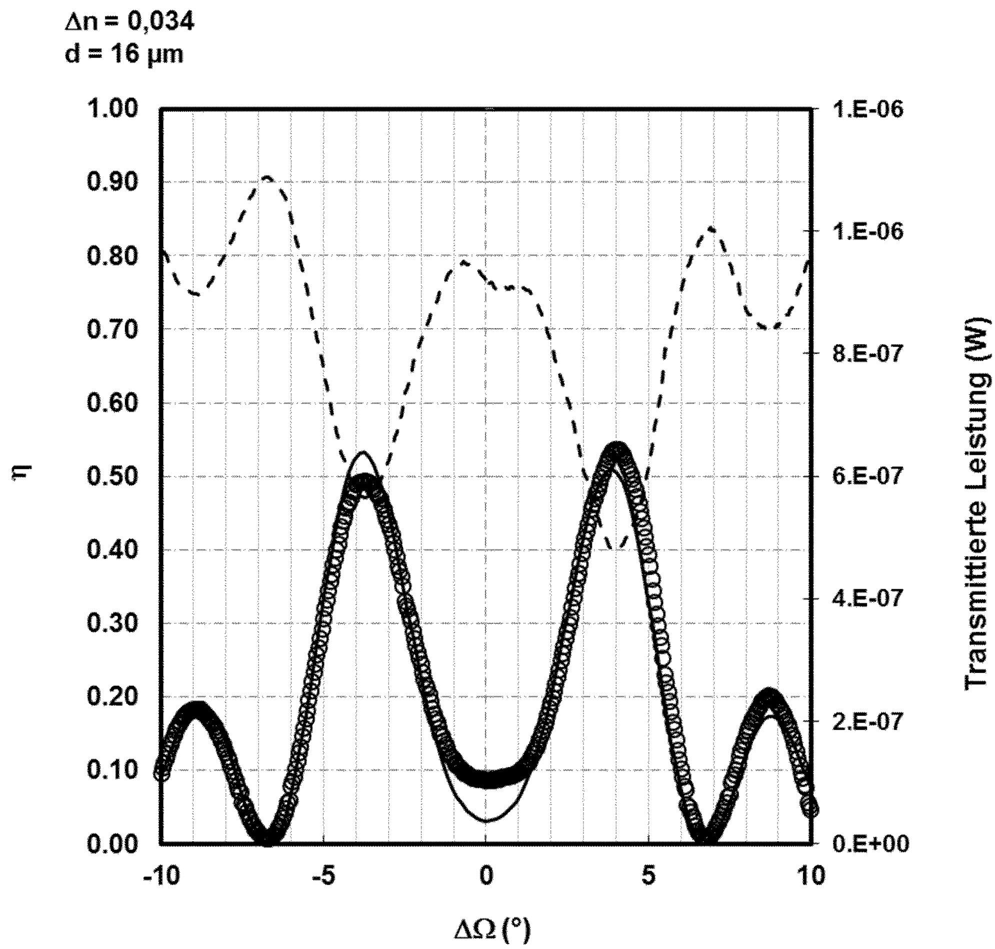
Δn = 0,034
d = 16 µm
η
1.00
0.90
0.80
0.70
0.60
0.50
0.40
0.30
0.20
0.10
0.00
-10
-5
0
5
10
ΔΩ (°)
1.E-06
1.E-06
8.E-07
6.E-07
4.E-07
2.E-07
0.E+00
Transmittierte Leistung (W)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 2749409 A1
- WO 2011067057 A1
- EP 2613319 A1
- WO 2011054797 A1
- EP 2218744 A1
- EP 1968057 A2
- JP H04214340 B
- US 4994347 A
- EP 0223587 A
- WO 2012062655 A
- WO 2013053791 A1
- EP 13189138


### In der Beschreibung aufgeführte Nicht-Patentliteratur


- **P. HARIHARAN.** Optical Holography. Cambridge University Press, 1996
- **H. BERNETH ; AZINE DYES.** Ullmann's Encyclopedia of Industrial Chemistry. Wiley-VCH Verlag, 2008
- **H. BERNETH.** Ullmann's Encyclopedia of Industrial Chemistry, Methine Dyes and Pigments. Wiley-VCH Verlag, 2008
- Triarylmethane and Diarylmethane Dyes. **T. GESSNER ; U. MAYER.** Ullmann's Encyclopedia of Industrial Chemistry. Wiley-VCH Verlag, 2000
- *J. Comput. Aid. Mol. Des.,* 2005, vol. 19, 453
- **CUNNINGHAM et al.** *RadTech'98 North America UV/EB Conference Proceedings,* 19. April 1998
- Chemistry & Technology of UV & EB Formulations For Coatings. **P. K. T. OLDRING.** Inks & Paints. SITA Technology, 1991, vol. 3, 61-328
- **HOUBEN-WEYL.** Methoden der organischen Chemie. Georg Thieme Verlag, 1961, vol. XIV/1, 433ff